# EUROPEAN PATENT APPLICATION

(11) **EP 4 443 896 A1**
(43) Date of publication of application: **09.10.2024**
(21) Application number: 22901045.9
(22) Date of filing: 09.11.2022
(51) Int. Cl.: H04N 25/60, H01L 27/146, H04N 25/53, H04N 25/533, H04N 25/70

(54) **IMAGING DEVICE AND CAMERA SYSTEM**

(30) Priority: 02.12.2021 JP 2021196518; 19.08.2022 JP 2022131133
(71) Applicant: Panasonic Intellectual Property Management Co., Ltd., Osaka-shi, Osaka 540-6207 (JP)
(72) Inventor: IIJIMA, Hiroaki, Kadoma-shi Osaka 571-0057 (JP); KISHIMOTO, Yuko, Kadoma-shi Osaka 571-0057 (JP)
(74) Representative: Grünecker Patent- und Rechtsanwälte PartG mbB
(86) International application number: PCT/JP2022/041783
(87) International publication number: WO 2023/100612

(57) **Abstract**

An imaging device includes a first pixel, a second pixel, and a first voltage supply circuit. The first pixel includes a first photoelectric converter that generates signal charge by photoelectric conversion and a first signal detection circuit connected to the first photoelectric converter. The second pixel includes a second photoelectric converter, stacked above the first photoelectric converter, that generates signal charge by photoelectric conversion and a second signal detection circuit connected to the second photoelectric converter. The first voltage supply circuit supplies a voltage to the first photoelectric converter. The first photoelectric converter includes a first pixel electrode, a first counter electrode facing the first pixel electrode, and a first photoelectric conversion layer located between the first pixel electrode and the first counter electrode. A voltage that the first voltage supply circuit applies between the first pixel electrode and the first counter electrode is switched between a plurality of voltages in part of a one-frame period excluding a readout period and a reset period of the second photoelectric converter 13b.

## Description

### Technical Field

The present disclosure relates to an imaging device and a camera system.

### Background Art

There have conventionally been known photoelectric conversion image sensors. For example, there has been widespread use of CMOS (complementary metal-oxide semiconductor) image sensors having photodiodes. Features of the CMOS image sensors include low power consumption and pixel-by-pixel accessibility. In general, the CMOS image sensors adopt, as a signal readout method, a so-called rolling shutter method by which exposures and signal charge readouts are performed in sequence for each separate row of a pixel array.

In the rolling shutter method, the starts and ends of exposures vary from one row of the pixel array to another. Therefore, imaging an object moving at high speed may give a distorted image of the object, or using the flash may result in a difference in brightness within an image. Under such circumstances, there is demand for a so-called global shutter function with which to start and end exposures at the same time for all pixels in the pixel array.

For example, PTL 1 discloses a method for, in a stacked image sensor whose circuit components and photoelectric converters are separate from each other, achieving a global shutter function by changing a voltage that is supplied to the photoelectric converters and thereby controlling the migration of signal charge from the photoelectric converters to charge storage regions.

Further, PTL 2 discloses a technology that makes it possible to, by stacking a plurality of photoelectric converters, take out signals representing each separate color and that makes it possible to, by connecting circuits separately to each of the photoelectric converters, individually control how the signals are read out.

Further, PTL 3 discloses a technology for, by stacking photoelectric conversion layers for the purpose of imaging visible light and near-infrared radiation, taking out signals separately from each of the photoelectric conversion layers.

### Citation List

### Patent Literature

PTL 1: Japanese Patent No. 6202512
PTL 2: U.S. Patent No. 9,277,146
PTL 3: Japanese Unexamined Patent Application Publication No. 2019-186738
PTL 4: U.S. Patent Application Publication No. 2007/0013798
PTL 5: Japanese Unexamined Patent Application Publication No. 2010-232410
PTL 6: Japanese Patent No. 5553727

### Summary of Invention

### Technical Problem

The present disclosure provides an imaging device and a camera system that make it possible to reduce image quality degradation in a case where a plurality of photoelectric converters are provided.

### Solution to Problem

An imaging device according to an aspect of the present disclosure includes a first pixel, a second pixel, and a first voltage supply circuit. The first pixel includes a first photoelectric converter that generates signal charge by photoelectric conversion and a first signal detection circuit connected to the first photoelectric converter. The second pixel includes a second photoelectric converter, stacked above the first photoelectric converter, that generates signal charge by photoelectric conversion and a second signal detection circuit connected to the second photoelectric converter. The first voltage supply circuit supplies a voltage to the first photoelectric converter. The first photoelectric converter includes a first pixel electrode, a first counter electrode facing the first pixel electrode, and a first photoelectric conversion layer located between the first pixel electrode and the first counter electrode. A voltage that the first voltage supply circuit applies between the first pixel electrode and the first counter electrode is switched between a plurality of voltages in part of a one-frame period excluding a readout period and a reset period of the second photoelectric converter.

A camera system according to an aspect of the present disclosure includes the imaging device and a lighting device that emits light including a luminescence peak in a wavelength range to which at least one of the first photoelectric converter and the second photoelectric converter has sensitivity. The lighting device emits the light in a period overlapping an exposure period of the at least one of the first photoelectric converter and the second photoelectric converter.

### Advantageous Effects of Invention

The present disclosure makes it possible to provide an imaging device and a camera system that make it possible to reduce image quality degradation.

### Brief Description of Drawings

[Fig. 1] Fig. 1 is a block diagram showing an example of a functional configuration of a camera system according to an embodiment.
[Fig. 2] Fig. 2 is a schematic view schematically showing a configuration of an imaging device according to the embodiment.
[Fig. 3A] Fig. 3A is a schematic view showing an exemplary circuit configuration of pixels each including a first photoelectric converter and peripheral circuits in the imaging device according to the embodiment.
[Fig. 3B] Fig. 3B is a schematic view showing an exemplary circuit configuration of pixels each including a second photoelectric converter and peripheral circuits in the imaging device according to the embodiment.
[Fig. 4] Fig. 4 is a cross-sectional view schematically showing an exemplary cross-section structure of pixels in the imaging device according to the embodiment.
[Fig. 5] Fig. 5 is a schematic view showing a configuration of another imaging device according to the embodiment.
[Fig. 6] Fig. 6 is a diagram showing an example of an absorbing spectrum in a photoelectric conversion layer containing tin naphthalocyanine.
[Fig. 7A] Fig. 7A is a cross-sectional view schematically showing an example of a configuration of a photoelectric conversion layer in a first photoelectric converter according to the embodiment.
[Fig. 7B] Fig. 7B is a cross-sectional view schematically showing an example of a configuration of a photoelectric conversion layer in a second photoelectric converter according to the embodiment.
[Fig. 8] Fig. 8 is a graph showing an exemplary photocurrent characteristic of a photoelectric conversion layer according to the embodiment.
[Fig. 9] Fig. 9 is a diagram for explaining Operation Example 1 of the imaging device according to the embodiment.
[Fig. 10] Fig. 10 is a diagram for explaining Operation Example 2 of the imaging device according to the embodiment.
[Fig. 11] Fig. 11 is a diagram for explaining a comparative example of operation of the imaging device.
[Fig. 12] Fig. 12 is a schematic view showing an exemplary circuit configuration of pixels each including a second photoelectric converter and peripheral circuits in an imaging device according to a modification.
[Fig. 13] Fig. 13 is a cross-sectional view schematically showing an exemplary cross-section structure of pixels in the imaging device according to the modification.
[Fig. 14] Fig. 14 is a diagram for explaining an operation example of the imaging device according to the modification.

### Description of Embodiments

### (Underlying Knowledge Forming Basis of Aspect of the Present Disclosure)

Prior to a specific description of an embodiment of the present disclosure, an underlying knowledge forming the basis of an aspect of the present disclosure is described. The inventors found the following problems in an imaging device including a plurality of photoelectric converters stacked.

In a case where a voltage that is supplied to a photoelectric converter is changed, for example, in an attempt to achieve a global shutter function in a case where at least some pixel circuits are separated from a plurality of photoelectric converters, a change in a voltage that is supplied to a first photoelectric converter causes a capacitance coupling between the first photoelectric converter and at least any of a second photoelectric converter, a signal detection circuit connected to the second photoelectric converter, and a charge storage region connected to the second photoelectric converter. Under the influence of this capacitance coupling, the capacitance of the charge storage region connected to the second photoelectric converter fluctuates, and this fluctuation causes image quality degradation. In particular, a fluctuation in the capacitance of the charge storage region in a period during which a signal is read out from the charge storage region and a period during which the potential of the charge storage region is reset greatly affects image quality.

The present disclosure was made on the basis of such findings and, by not changing, at a particular timing, a voltage that is applied to a photoelectric converter in an imaging device including a plurality of photoelectric converters, reduces the influence of a capacitance coupling between a first photoelectric converter and at least any of a second photoelectric converter, a signal detection circuit connected to the second photoelectric converter, and a charge storage region connected to the second photoelectric converter, thus providing an imaging device and a camera system that make it possible to reduce image quality degradation. The following gives a detailed description.

### (Brief Overview of the Present Disclosure)

As a brief overview of the present disclosure, the following gives examples of an imaging device and a camera system according to the present disclosure.

An imaging device according to a first aspect of the present disclosure includes a first pixel, a second pixel, and a first voltage supply circuit. The first pixel includes a first photoelectric converter that generates signal charge by photoelectric conversion and a first signal detection circuit connected to the first photoelectric converter. The second pixel includes a second photoelectric converter, stacked above the first photoelectric converter, that generates signal charge by photoelectric conversion and a second signal detection circuit connected to the second photoelectric converter. The first voltage supply circuit supplies a voltage to the first photoelectric converter. The first photoelectric converter includes a first pixel electrode, a first counter electrode facing the first pixel electrode, and a first photoelectric conversion layer located between the first pixel electrode and the first counter electrode. A voltage that the first voltage supply circuit applies between the first pixel electrode and the first counter electrode is switched between a plurality of voltages in part of a one-frame period excluding a readout period and a reset period of the second photoelectric converter.

In such an imaging device having a plurality of photoelectric converters, a capacitance coupling is formed between the first photoelectric converter and at least any of the second photoelectric converter, the second signal detection circuit, and a region in which to store signal charge generated by the second photoelectric converter. When switching of the voltage that is applied to the first photoelectric converter is not performed in the readout period or the reset period of the second photoelectric converter, a change in the capacitance with which to store signal charge that the second photoelectric converter generates does not take place in the readout period or the reset period. Therefore, an output signal from the second signal detection circuit does not fluctuate in the readout period or the reset period, so that image quality degradation due to a capacitance coupling between the first photoelectric converter and at least any of the second photoelectric converter, the second signal detection circuit, and the region in which to store signal charge generated by the second photoelectric converter can be reduced.

Further, for example, an imaging device according to a second aspect of the present disclosure may be directed to the imaging device according to the first aspect, wherein the first pixel and the second pixel may be effective pixels.

This makes it possible to reduce the influence of the aforementioned capacitance coupling in the effective pixels, which directly affect output signals.

Further, for example, an imaging device according to a third aspect of the present disclosure may be directed to the imaging device according to the first or second aspect, wherein the first photoelectric converter may have sensitivity that is able to be changed by the voltage that is applied between the first pixel electrode and the first counter electrode being switched between the plurality of voltages.

This makes it possible to adjust sensitivity during imaging with the first photoelectric converter simply by switching of the applied voltage.

Further, for example, an imaging device according to a fourth aspect of the present disclosure may be directed to the imaging device according to the third aspect, wherein the first photoelectric converter may be driven by a global shutter method by which an exposure period is defined by the voltage that is applied between the first pixel electrode and the first counter electrode being switched between the plurality of voltages.

This makes it possible to reduce distortions in an image of a rapidly moving object during imaging with the first photoelectric converter.

Further, for example, an imaging device according to a fifth aspect of the present disclosure may be directed to the imaging device according to the first or second aspect, further including a second voltage supply circuit that supplies a voltage to the second photoelectric converter. The second photoelectric converter may include a second pixel electrode, a second counter electrode facing the second pixel electrode, and a second photoelectric conversion layer located between the second pixel electrode and the second counter electrode. The second photoelectric converter may have sensitivity that is able to be changed by a voltage that is applied between the second pixel electrode and the second counter electrode being switched between a plurality of voltages. The second photoelectric converter may be driven by a global shutter method by which an exposure period is defined by the voltage that is applied between the second pixel electrode and the second counter electrode being switched between the plurality of voltages.

This makes it possible to reduce distortions in an image of a rapidly moving object during imaging with the second photoelectric converter.

Further, for example, an imaging device according to a sixth aspect of the present disclosure may be directed to the imaging device according to any one of the first to fifth aspects, wherein an exposure period and a readout period of the first photoelectric converter may be included within an exposure period of the second photoelectric converter.

This makes it possible to lengthen the exposure period of the second photoelectric converter without lengthening a one-frame period, making it possible to increase sensitivity during imaging with the second photoelectric converter.

Further, for example, an imaging device according to a seventh aspect of the present disclosure may be directed to the imaging device according to any one of the first to sixth aspects, wherein an exposure period and a readout period of the first photoelectric converter may be included in this order within an exposure period of the second photoelectric converter.

This makes it possible to shorten the interval between the exposure period and the readout period of the first photoelectric converter. This makes it possible, for example, to reduce degradation in image quality by reducing the influence of a dark current during imaging with the first photoelectric converter. This also makes it possible, for example, to reduce degradation in image quality due to unintended parasitic sensitivity in a period other than the exposure period during imaging with the first photoelectric converter.

Further, for example, an imaging device according to an eighth aspect of the present disclosure may be directed to the imaging device according to the seventh aspect, wherein a reset period, the exposure period, and the readout period of the first photoelectric converter may be included in this order within the exposure period of the second photoelectric converter.

This makes it possible to shorten the interval between the reset period and the readout period of the first photoelectric converter. This makes it possible, for example, to reduce degradation in image quality by reducing the influence of a dark current during imaging with the first photoelectric converter. This also makes it possible, for example, to further reduce degradation in image quality due to unintended parasitic sensitivity in a period other than the exposure period during imaging with the first photoelectric converter.

Further, for example, an imaging device according to a ninth aspect of the present disclosure may be directed to the imaging device according to any one of the first to eighth aspects, further including a third photoelectric converter stacked above the first photoelectric converter and the second photoelectric converter and including a third signal detection circuit connected to the third photoelectric converter.

This makes it possible to increase the number of types of signal that can be acquired by each photoelectric converter. For example, in a case where there are provided three photoelectric converters separately having sensitivity to red, green, and blue wavelength regions, it becomes possible to easily acquire a color image. Further, in a case where the imaging device is provided with four photoelectric converters separately having sensitivity to red, green, and blue, and near-infrared wavelength regions, a color image and a near-infrared image can be easily acquired.

Further, for example, an imaging device according to a tenth aspect of the present disclosure may be directed to the imaging device according to any one of the first to ninth aspects, wherein a first one of the first photoelectric converter and the second photoelectric converter may have sensitivity to a near-infrared wavelength region, and a second one of the first photoelectric converter and the second photoelectric converter may have sensitivity to a visible light wavelength region.

This makes it possible to acquire a visible light image and a near-infrared image with one imaging device.

Further, for example, an imaging device according to an eleventh aspect of the present disclosure may be directed to the imaging device according to the tenth aspect, wherein an exposure period of the first one of the first photoelectric converter and the second photoelectric converter may be shorter than an exposure period of the second one of the first photoelectric converter and the second photoelectric converter.

This makes it possible to shorten an exposure period in which to acquire a near-infrared image. A photoelectric converter having sensitivity to the near-infrared wavelength region tends to produce a dark current due to thermal excitation, as the photoelectric converter is made of a photoelectric conversion material having a narrow bandgap. The shortening of an exposure period in which to acquire a near-infrared image reduces the influence of a dark current even in a case where a dark current tends to be produced, making it possible to reduce degradation in image quality.

Further, for example, an imaging device according to a twelfth aspect of the present disclosure may be directed to the imaging device according to any one of the first to eleventh aspects, wherein the second photoelectric converter may include a silicon photodiode.

This makes it possible to make the imaging device simple in configuration.

Further, a camera system according to a thirteenth aspect of the present disclosure includes the imaging device according to any one of the first to twelfth aspects and a lighting device that emits light including a luminescence peak in a wavelength range to which at least one of the first photoelectric converter and the second photoelectric converter has sensitivity. The lighting device emits the light in a period overlapping an exposure period of the at least one of the first photoelectric converter and the second photoelectric converter.

This makes it possible to take an image with the light emitted by the lighting device, making it possible to improve the image quality of the image taken.

The following describes the present embodiment in concrete terms with reference to the drawings.

It should be noted that the embodiments to be described below each illustrate a comprehensive and specific example. The numerical values, shapes, materials, constituent elements, placement and topology of constituent elements, steps, orders of steps, or other features that are shown in the following embodiments are just a few examples and are not intended to limit the present disclosure. Further, those of the constituent elements in the following embodiments which are not recited in an independent claim are described as optional constituent elements. Further, the drawings are not necessarily strict illustrations. Further, in the drawings, substantially the same components are given the same reference signs, and a repeated description may be omitted or simplified.

Further, terms used herein to show the way in which elements are interrelated, terms used herein to show the shape of an element, and ranges of numerical values used herein are not expressions that represent only exact meanings but expressions that are meant to also encompass substantially equivalent ranges, e.g. differences of approximately several percent.

Further, the terms "above" and "below" used herein do not refer to an upward direction (upward in a vertical direction) and a downward direction (downward in a vertical direction) in absolute space recognition, but are used as terms that are defined by a relative positional relationship on the basis of an order of stacking in a stack configuration. Specifically, the term "above" refers to a light receiving side of an imaging device, and the term "below" refers to a side of the imaging device that faces away from the light receiving side. It should be noted that terms such as "above" and "below" are used solely to designate the mutual placement of members and are not intended to limit the attitude of the imaging device during use. Further, the terms "above" and "below" are applied not only in a case where two constituent elements are placed at a spacing from each other and another constituent element is present between the two constituent elements, but also in a case where two constituent elements are placed in close contact with each other and the two constituent elements touch each other.

### (Embodiment)

The following describes an imaging device according to the present embodiment and a camera system including an imaging device and a lighting device according to the present embodiment.

### [Camera System]

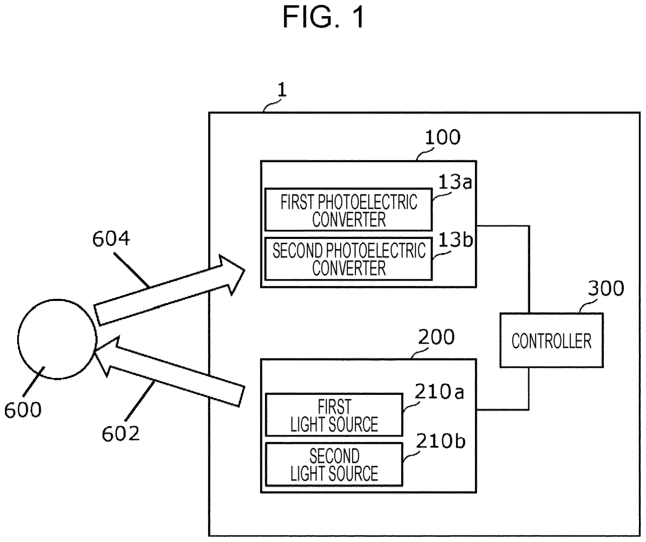

First, the camera system according to the present embodiment is described. Fig. 1 is a block diagram showing an example of a functional configuration of the camera system according to the present embodiment.

As shown in Fig. 1, the camera system 1 includes an imaging device 100, a lighting device 200, and a controller 300.

The camera system 1 is configured such that illuminating light 602 emitted by the lighting device 200 is reflected off a subject 600. Reflected light 604 produced by the illuminating light 602 being reflected off the subject 600 is taken out as an electrical signal for imaging by being converted into electric charge by a photoelectric converter of the imaging device 100.

Although, in the example shown in Fig. 1, the imaging device 100, the lighting device 200, and the controller 300 are shown as separate functional blocks, two or more of the imaging device 100, the lighting device 200, and the controller 300 may be integrated. For example, the imaging device 100 may include the lighting device 200.

The imaging device 100 converts light falling on the camera system 1 into an electric signal and outputs an image (image signal). The imaging device 100 includes a first photoelectric converter 13a and a second photoelectric converter 13b. The first photoelectric converter 13a and the second photoelectric converter 13b are each for example a photoelectric conversion element. On the first photoelectric converter 13a and the second photoelectric converter 13b, for example, light based on lighting or, specifically, reflected light produced by the illuminating light emitted by the lighting device 200 being reflected off the subject falls. The first photoelectric converter 13a and the second photoelectric converter 13b each generate signal charge by photoelectric conversion. Signals corresponding to the amounts of signal charge generated separately by each of the first and second photoelectric converters 13a and 13b are read out and outputted as image signals from the imaging device 100.

The first photoelectric converter 13a and the second photoelectric converter 13b have sensitivity to wavelength ranges differing from each other. The first photoelectric converter 13a has sensitivity to a first wavelength range. The second photoelectric converter 13b has sensitivity to a second wavelength range. The configuration of the imaging device 100 will be described in detail later. Having sensitivity to a certain wavelength herein means having an external quantum efficiency of 1% or higher at a certain wavelength.

The lighting device 200 illuminates the subject with the illuminating light. The lighting device 200 produces, as the illuminating light, light having a luminescence peak in a wavelength range to which at least one of the first photoelectric converter 13a and the second photoelectric converter 13b has sensitivity. The lighting device 200 includes, for example, a first light source 210a and a second light source 210b.

The first light source 210a emits, for example, light containing a component having a wavelength in at least part of the first wavelength range to which the first photoelectric converter 13a has sensitivity. The first light source 210a emits, for example, light having a luminescent peak in the first wavelength range.

The second light source 210b emits, for example, light containing a component having a wavelength in at least part of the second wavelength range to which the second photoelectric converter 13b has sensitivity. The second light source 210b emits, for example, light having a luminescent peak in the second wavelength range.

Types of light source that are used as the first light source 210a and the second light source 210b are not limited to particular types, provided the light sources can emit light of desired wavelengths. The first light source 210a and the second light source 210b are each for example a halogen light source, an LED (light-emitting diode) light source, an organic EL (electroluminescence) light source, a laser diode light source, or other light sources. Further, with the first light source 210a and the second light source 210b, a plurality of light sources differing in luminous wavelength from each other may be combined for use.

The first wavelength range and the second wavelength range are each for example a wavelength range included in any of an ultraviolet wavelength region, a visible light wavelength region, and a near-infrared wavelength region. Further, the first photoelectric converter 13a may have sensitivity to a wavelength outside the first wavelength range. Further, the second photoelectric converter 13b may have sensitivity to a wavelength outside the second wavelength range.

As specific examples, the first wavelength range is a range of wavelengths in the near-infrared wavelength region, and the second wavelength range is a range of wavelengths in the visible light wavelength region. Therefore, the first light source 210a emits light having a luminescent peak in the near-infrared wavelength region. Further, the second light source 210b emits light having a luminescent peak in the visible light wavelength region. In this case, the light emitted by the first light source 210a is converted by the first photoelectric converter 13a, which has sensitivity to the near-infrared wavelength region, and taken out as an electrical signal for imaging. Further, the light emitted by the second light source 210b is converted by the second photoelectric converter 13b, which has sensitivity to the visible light wavelength region, and taken out as an electrical signal for imaging. This allows the imaging device 100 to separately take out signals corresponding to visible light and near-infrared radiation. This makes it possible, for example, to acquire a visible light image and a near-infrared image.

The near-infrared wavelength region herein refers, for example, to a region of wavelengths longer than or equal to 680 nm and shorter than or equal to 3000 nm. The near-infrared wavelength region may refer to a region of wavelengths longer than or equal to 700 nm and shorter than or equal to 2000 nm, or may refer to a region of wavelengths longer than or equal to 700 nm and shorter than or equal to 1600 nm. Further, the visible light wavelength region refers, for example, to a region of wavelengths longer than or equal to 380 nm and shorter than 680 nm. Further, the ultraviolet wavelength region may refer to a region of wavelengths longer than or equal to 100 nm and shorter than 380 nm, or may refer to a region of wavelengths longer than or equal to 200 nm and shorter than 380 nm. All electromagnetic waves including visible light, infrared radiation, and ultraviolet radiation are herein expressed as "light" for convenience.

Further, for example, the first wavelength range may be a range of wavelengths in the ultraviolet wavelength region, and the second wavelength range may be a range of wavelengths in the visible light wavelength region. This allows the imaging device 100 to separately take out signals corresponding to visible light and ultraviolet radiation. This makes it possible, for example, to acquire a visible light image and an ultraviolet image.

Further, for example, the first wavelength range and the second wavelength range may each be a range of wavelengths in the near-infrared wavelength region. This allows the imaging device 100 to separately take out signals corresponding to near-infrared radiation of different wavelengths. This makes it possible, for example, to acquire two types of near-infrared image of different wavelengths. For example, by generating a difference image using such two types of near-infrared image, a near-infrared image less influenced by ambient light or moisture absorption can be obtained.

Further, in a case where at least one of the first wavelength range and the second wavelength range is a range of wavelengths in the near-infrared wavelength region, the at least one may be a range of wavelengths longer than or equal to 820 nm and shorter than or equal to 980 nm. This makes it possible to use, as a light source of the lighting device 200, which emits the illuminating light, an inexpensive LED light source having a luminescent peak at a wavelength longer than or equal to 820 nm and shorter than or equal to 980 nm.

It should be noted that the number of light sources that the lighting device 200 has is not limited to 2 but may be 1 or may be larger than or equal to 3. For example, the lighting device 200 may be configured to include only the first light source 210a or the second light source 210b as a light source. In this case, for example, the first photoelectric converter 13a or the second photoelectric converter 13b converts, into electric charge, reflected light produced by ambient light or light from an external light source being reflected off the subject. Further, the first light source 210a and the second light source 210b do not need to be provided in one lighting device, and the camera system 1 may include a lighting device having the first light source 210a and a lighting device including the second light source 210b. Further, the camera system 1 does not need to include the lighting device 200.

Further, the first wavelength range and the second wavelength range illustrated in the foregoing description may swap their ranges of wavelengths with each other. For example, the first wavelength range is a range of wavelengths in the visible light wavelength region, and the second wavelength range may be a range of wavelengths in the near-infrared wavelength region.

The controller 300 is a control circuit that controls how the imaging device 100 and the lighting device 200 operate. The controller 300 for example outputs various types of driving signal to the imaging device 100 and the lighting device 200. The controller 300 is implemented, for example, by a microcomputer. Functions of the controller 300 may be implemented by a combination of a general-purpose processing circuit and software, or may be implemented by hardware specialized in such processing.

Further, at least some of the functions of the controller 300, e.g. a function of controlling how the imaging device 100 is driven, may be included in the imaging device 100. That is, the controller 300 may be provided as a control circuit or other circuits in the imaging device 100. Therefore, the after-mentioned peripheral circuits and pixels of the imaging device 100 may be driven under the control of a controller 300 provided outside the imaging device 100, or may be driven under the control of a control circuit (controller 300) provided in the imaging device 100.

### [Imaging Device]

Next, the imaging device according to the present embodiment is described in detail.

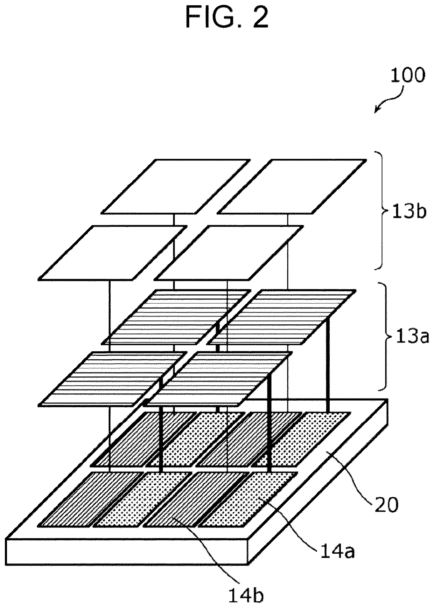

Fig. 2 is a schematic view schematically showing a configuration of the imaging device according to the present embodiment. Fig. 2 schematically shows photoelectric converters of each separate pixel of the imaging device 100 according to the present embodiment and signal detection circuits connected to the photoelectric converters.

As shown in Fig. 2, the imaging device 100 includes a first photoelectric converter 13a, a signal detection circuit 14a connected to the first photoelectric converter 13a, a second photoelectric converter 13b, a signal detection circuit 14b connected to the second photoelectric converter 13b, and a semiconductor substrate 20 provided with the signal detection circuit 14a and the signal detection circuit 14b. The signal detection circuit 14a is an example of the first signal detection circuit. The signal detection circuit 14b is an example of the second signal detection circuit.

The first photoelectric converter 13a and the second photoelectric converter 13b are sacked above the semiconductor substrate 20. This makes it possible to place a plurality of photoelectric converters in the same photosensitive region. This makes it possible to increase the number of pixels even in a case where signals corresponding to multiple rays of light are outputted, making it possible to improve image quality. Although Fig. 2 shows first photoelectric converters 13a for four pixels and second photoelectric converters 13b for four pixels, the number of pixels in a first photoelectric converter 13a and the number of pixels in a second photoelectric converter 13b are not limited to particular numbers. Further, the number of pixels in a first photoelectric converter 13a and the number of pixels in a second photoelectric converter 13b may be equal to or different from each other. For example, although Fig. 2 illustrates an example in which second photoelectric converters 13b of four pixels are stacked above first photoelectric converters 13a of four pixels, second photoelectric converters 13b of four pixels may be stacked above a first photoelectric converter 13a of one pixel.

Further, the first photoelectric converter 13a and the second photoelectric converter 13b may both have sensitivity to at least any of visible light, near-infrared radiation, infrared radiation, and ultraviolet radiation. Further, for example, a Bayer color filter array may be provided above a second photoelectric converter 13b having sensitivity to the entire visible light wavelength region, and each pixel provided in the second photoelectric converter 13b may output, according to a corresponding color filter, a pixel signal corresponding to the intensity of red, blue, or green light. Further, for example, each pixel provided in a first photoelectric converter 13a having sensitivity to the near-infrared wavelength region may output a pixel signal corresponding to the intensity of near-infrared radiation. This gives a color image corresponding to signal charge of the second photoelectric converter 13b and a near-infrared image corresponding to signal charge of the first photoelectric converter 13a.

In the example shown in Fig. 2, the signal detection circuit 14a and the signal detection circuit 14b are formed in the same plane on the semiconductor substrate 20. It should be noted that the signal detection circuit 14a and the signal detection circuit 14b may be formed side by side in the same plane over the semiconductor substrate 20 as shown in Fig. 2, or may be formed separately in upper and lower planes differing from each other.

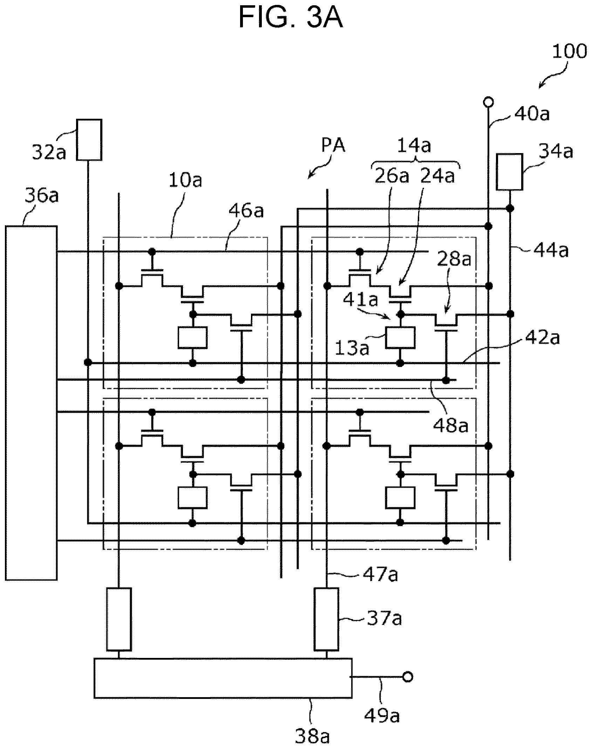

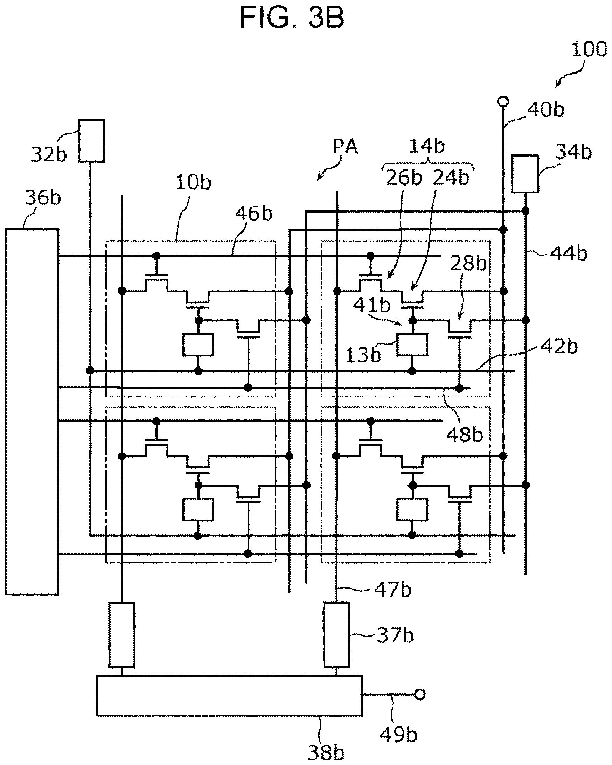

Next, a circuit configuration of the imaging device 100 according to the present embodiment is described. Fig. 3A is a schematic view showing an exemplary circuit configuration of pixels each including a first photoelectric converter and peripheral circuits in the imaging device according to the present embodiment. Fig. 3B is a schematic view showing an exemplary circuit configuration of pixels each including a second photoelectric converter and peripheral circuits in the imaging device according to the present embodiment.

As shown in Figs. 3A and 3B, the imaging device 100 includes a plurality of pixels and peripheral circuits, and the plurality of pixels include a plurality of pixels 10a and a plurality of pixels 10b. In particular, the imaging device 100 includes a pixel array PA and peripheral circuits, and the pixel array PA includes a plurality of pixels 10a arrayed two-dimensionally and a plurality of pixels 10b arrayed two-dimensionally. Fig. 3A schematically shows an example in which the pixels 10a are arranged in two rows and two columns in a matrix, and Fig. 3B schematically shows an example in which the pixels 10b are arranged in two rows and two columns in a matrix. At least part of each of the pixels 10a is constituted by a first photoelectric converter 13a and a signal detection circuit 14a, and at least part of each of the pixels 10b is constituted by a second photoelectric converter 13b and a signal detection circuit 14b. In the pixel array PA, as mentioned above, the first photoelectric converters 13a of the pixels 10a and the second photoelectric converters 13b of the pixels 10b are stacked. The numbers and arrangements of pixels 10a and pixels 10b in the imaging device 100 are not limited to the examples shown in Figs. 3A and 3B. In the present embodiment, each of the pixels 10a is an example of the first pixel, and each of the pixels 10b is an example of the second pixel.

The pixels 10a and the pixels 10b are for example effective pixels. The effective pixels here are pixels that are actually used for outputting an image or pixels that are used for sensing, and do not include optically black pixels and dummy pixels that are used for measuring dark noise. It should be noted at least either the pixels 10a or 10b may be optically black pixels or dummy pixels.

The peripheral circuits for example drive the pixel array PA and acquire an image based on signal charge generated by the first photoelectric converters 13a and the second photoelectric converters 13b. The peripheral circuits include, for example, a voltage supply circuit 32a ,a reset voltage source 34a, a vertical scanning circuit 36a, column signal processing circuits 37a, and a horizontal signal readout circuit 38a that are connected to the pixels 10a, a voltage source connected to a power wire 40a, or other circuits. Further, the peripheral circuits include, for example, a voltage supply circuit 32b, a reset voltage source 34b, a vertical scanning circuit 36b, column signal processing circuits 37b, and a horizontal signal readout circuit 38b that are connected to the pixels 10b, a voltage source connected to a power wire 40b, or other circuits. Further, the imaging device 100 may include, as circuits included in the peripheral circuits, control circuits that control how peripheral circuits other than those of the imaging device 100 are driven.

The circuit configuration of the pixels 10a shown in Fig. 3A and the peripheral circuits connected to the pixels 10a is for example functionally similar to the circuit configuration of the pixels 10b shown in Fig. 3B and the peripheral circuits connected to the pixels 10b. A circuit configuration concerning pixels 10a each having a first photoelectric converter 13a and pixels 10b each having a second photoelectric converter 13b is described with reference to Figs. 3A and 3B.

Each pixel 10a has a first photoelectric converter 13a and a signal detection circuit 14a. Each pixel 10b has a second photoelectric converter 13b and a signal detection circuit 14b. As will be described later with reference to the drawings, the first photoelectric converter 13a and the second photoelectric converter 13b each have a photoelectric conversion layer sandwiched between two electrodes facing each other and generate signal charge upon receiving incident light. The first photoelectric converter 13a does not need to be an element that is independent in its entirety for each pixel 10a, and for example, a portion of the first photoelectric converter 13a may lie astride a plurality of pixels 10a. Further, the second photoelectric converter 13b does not need to be an element that is independent in its entirety for each pixel 10b, and for example, a portion of the second photoelectric converter 13b may lie astride a plurality of pixels 10b.

The signal detection circuit 14a is a circuit that detects signal charge generated by the first photoelectric converter 13a. The signal detection circuit 14b is a circuit that detects signal charge generated by the second photoelectric converter 13b. In this example, the signal detection circuit 14a includes a signal detection transistor 24a and an address transistor 26a. Further, the signal detection circuit 14b includes a signal detection transistor 24b and an address transistor 26b. The signal detection transistors 24a and 24b and the address transistors 26a and 26b are each for example a field-effect transistor (FET), and for example, as the signal detection transistors 24a and 24b and the address transistors 26a and 26b, N-channel MOSFETs (metal-oxide semiconductor field-effect transistors) are illustrated here. Each transistor such as the signal detection transistors 24a and 24b, the address transistors 26a and 26b, and the after-mentioned reset transistors 28a and 28b has a control terminal, an input terminal, and an output terminal. The control terminal is for example a gate. The input terminal is one of a drain and a source, and is for example a drain. The output terminal is the other of a drain and a source, and is for example a source.

As schematically shown in Fig. 3A, the control terminal of the signal detection transistor 24a has an electrical connection to the first photoelectric converter 13a. Signal charge generated by the first photoelectric converter 13a is stored in a region including a charge storage node 41a between the gate of the signal detection transistor 24a and the first photoelectric converter 13a. As schematically shown in Fig. 3B, the control terminal of the signal detection transistor 24b has an electrical connection to the second photoelectric converter 13b. Signal charge generated by the second photoelectric converter 13b is stored in a region including a charge storage node 41b between the gate of the signal detection transistor 24b and the second photoelectric converter 13b. Note here that the signal charge is a hole or an electron. A charge storage node is at least part of a charge storage region in which signal charge is stored, and is also called "floating diffusion node". Structures of the first photoelectric converter 13a and the second photoelectric converter 13b will be described in detail later.

The first photoelectric converter 13a of each pixel 10a further has a connection to a sensitivity control line 42a. In the configuration illustrated in Fig. 3A, the sensitivity control line 42a is connected to the voltage supply circuit 32a. The second photoelectric converter 13b of each pixel 10b further has a connection to a sensitivity control line 42b. In the configuration illustrated in Fig. 3B, the sensitivity control line 42b is connected to the voltage supply circuit 32b. A voltage supply circuit is also called "sensitivity control electrode supply circuit". The voltage supply circuits 32a and 32b are each a circuit configured to be able to supply at least two types of voltage.

The voltage supply circuit 32a is an example of the first voltage supply circuit that supplies a voltage to the first photoelectric converter 13a. Specifically, the voltage supply circuit 32a supplies a predetermined voltage to the first photoelectric converter 13a via the sensitivity control line 42a during operation of the imaging device 100. The voltage supply circuit 32b is an example of the second voltage supply circuit that supplies a voltage to the second photoelectric converter 13b. Specifically, the voltage supply circuit 32b supplies a predetermined voltage to the second photoelectric converter 13b via the sensitivity control line 42b during operation of the imaging device 100. The voltage supply circuits 32a and 32b are not limited to particular power circuits but may be circuits that generate predetermined voltages or may be circuits that convert voltages supplied from other power supplies into predetermined voltages. As will be described in detail later, by switching, between a plurality of voltages differing from each other, the voltage that is supplied from the voltage supply circuit 32a to the first photoelectric converter 13a, the start and end of storage of signal charge from the first photoelectric converter 13a into the charge storage node 41a are controlled. Further, by switching, between a plurality of voltages differing from each other, the voltage that is supplied from the voltage supply circuit 32b to the second photoelectric converter 13b, the start and end of storage of signal charge from the second photoelectric converter 13b into the charge storage node 41b are controlled. In other words, in the present embodiment, an electronic shutter operation is executed by switching the voltage that is supplied from the voltage supply circuit 32a to the first photoelectric converter 13a and the voltage that is supplied from the voltage supply circuit 32b to the second photoelectric converter 13b. An example of operation of the imaging device 100 will be described later.

Each pixel 10a has a connection to the power wire 40a, which supplies a power supply voltage VDD. Each pixel 10b has a connection to the power wire 40b, which supplies the power supply voltage VDD. As shown in Fig. 3A, to the power wire 40a, the input terminal of the signal detection transistor 24a is connected. The functioning of the power wire 40a as a source follower power supply causes the signal detection transistor 24a to amplify and output a signal generated by the first photoelectric converter 13a. Further, as shown in Fig. 3B, to the power wire 40b, the input terminal of the signal detection transistor 24b is connected. The functioning of the power wire 40b as a source follower power supply causes the signal detection transistor 24b to amplify and output a signal generated by the second photoelectric converter 13b.

To the output terminal of the signal detection transistor 24a, the input terminal of the address transistor 26a is connected. The output terminal of the address transistor 26a is connected to one of a plurality of vertical signal lines 47a placed separately for each of the rows of pixels 10a in the pixel array PA. The control terminal of the address transistor 26a is connected to an address control line 46a, and by controlling the potential of the address control line 46a, an output from the signal detection transistor 24a can be selectively read out to a corresponding one of the vertical signal lines 47a.

Further, to the output terminal of the signal detection transistor 24b, the input terminal of the address transistor 26b is connected. The output terminal of the address transistor 26b is connected to one of a plurality of vertical signal lines 47b placed separately for each of the rows of pixels 10b in the pixel array PA. The control terminal of the address transistor 26b is connected to an address control line 46b, and by controlling the potential of the address control line 46b, an output from the signal detection transistor 24b can be selectively read out to a corresponding one of the vertical signal lines 47b.

In the example shown in Fig. 3A, the address control line 46a is connected to the vertical scanning circuit 36a. Further, in the example shown in Fig. 3B, the address control line 46b is connected to the vertical scanning circuit 36b. A vertical scanning circuit is also called "row scanning circuit". The vertical scanning circuit 36a applies a predetermined voltage to the address control line 46a and thereby selects, on a row-by-row basis, a plurality of pixels 10a arranged in each row. The vertical scanning circuit 36b applies a predetermined voltage to the address control line 46b and thereby selects, on a row-by-row basis, a plurality of pixels 10b arranged in each row. In this way, the reading out of signals from the pixels 10a and 10b thus selected and the after-mentioned resetting of pixel electrodes are executed.

The vertical signal lines 47a are main signal lines through which pixel signals from the plurality of pixels 10a of the pixel array PA are transmitted to the peripheral circuits. To the vertical signal lines 47a, the column signal processing circuits 37a are connected. Further, the vertical signal lines 47b are main signal lines through which pixel signals from the plurality of pixels 10b of the pixel array PA are transmitted to the peripheral circuits. To the vertical signal lines 47b, the column signal processing circuits 37b are connected. A column signal processing circuit is also called "row signal storage circuit". The column signal processing circuits 37a and 37b each perform noise suppression signal processing typified by correlated double sampling and analog-to-digital conversion (AD conversion). As shown in Fig. 3A, the column signal processing circuits 37a are provided separately in correspondence with each of the rows of pixels 10a in the pixel array PA. To these column signal processing circuits 37a, the horizontal signal readout circuit 38a is connected. As shown in Fig. 3B, the column signal processing circuits 37b are provided separately in correspondence with each of the rows of pixels 10b in the pixel array PA. To these column signal processing circuits 37b, the horizontal signal readout circuit 38b is connected. A horizontal signal readout circuit is also called "column scanning circuit".

The horizontal signal readout circuit 38a sequentially reads out signals from the plurality of column signal processing circuits 37a to a horizontal common signal line 49a. Further, the horizontal signal readout circuit 38b sequentially reads out signals from the plurality of column signal processing circuits 37b to a horizontal common signal line 49b.

In the configuration illustrated in Fig. 3A, each of the pixels 10a has a reset transistor 28a. Further, in the configuration illustrated in Fig. 3B, each of the pixels 10b has a reset transistor 28b. The reset transistors 28a and 28b may each be, for example, a field-effect transistor as is the case with the signal detection transistors 24a and 24b and the address transistors 26a and 26b. Unless otherwise noted, the following describes an example in which N-channel MOSFETs are applied as the reset transistors 28a and 28b.

As shown in Fig. 3A, the reset transistor 28a is connected between a reset voltage line 44a that supplies a reset voltage Vr and the charge storage node 41a. The control terminal of the reset transistor 28a is connected to a reset control line 48a, and by controlling the potential of the reset control line 48a, the potential of the charge storage node 41a can be reset to the reset voltage Vr. In this example, the reset control line 48a is connected to the vertical scanning circuit 36a. Accordingly, the application of a predetermined voltage to the reset control line 48a by the vertical scanning circuit 36a makes it possible to reset, on a row-by-row basis, a plurality of pixels 10a arranged in each row. Further, as shown in Fig. 3B, the reset transistor 28b is connected between a reset voltage line 44b that supplies the reset voltage Vr and the charge storage node 41b. The control terminal of the reset transistor 28b is connected to a reset control line 48b, and by controlling the potential of the reset control line 48b, the potential of the charge storage node 41b can be reset to the reset voltage Vr. In this example, the reset control line 48b is connected to the vertical scanning circuit 36b. Accordingly, the application of a predetermined voltage to the reset control line 48b by the vertical scanning circuit 36b makes it possible to reset, on a row-by-row basis, a plurality of pixels 10b arranged in each row.

In this example, the reset voltage line 44a, which supplies the reset voltage Vr to the reset transistor 28a, is connected to the reset voltage source 34a. Further, the reset voltage line 44b, which supplies the reset voltage Vr to the reset transistor 28b, is connected to the reset voltage source 34b. A reset voltage source is also called "reset voltage supply circuit". The reset voltage sources 34a and 34b need only be configured to be able to supply the predetermined reset voltage Vr to the reset voltage lines 44a and 44b during operation of the imaging device 100 and, as is the case with the aforementioned voltage supply circuits 32a and 32b, are not limited to particular power circuits. Each of the power supply circuits 32a and 32b and the reset voltage sources 34a and 34b may be a portion of a single voltage supply circuit, or may be an independent and separate voltage supply circuit. It should be noted that either or both of the voltage supply circuit 32a and the reset voltage source 34a may be a portion of the vertical scanning circuit 36a. Alternatively, a sensitivity control voltage from the power supply circuit 32a and/or the reset voltage Vr from the reset voltage source 34a may be supplied to each pixel 10a via the vertical scanning circuit 36a. Further, either or both of the voltage supply circuit 32b and the reset voltage source 34b may be a portion of the vertical scanning circuit 36b. Alternatively, a sensitivity control voltage from the power supply circuit 32b and/or the reset voltage Vr from the reset voltage source 34b may be supplied to each pixel 10b via the vertical scanning circuit 36b.

It is also possible to use the power supply voltage VDD of the signal detection circuits 14a and 14b as the reset voltage Vr. In this case, commonality may be achieved between a voltage supply circuit (not illustrated in Fig. 3A) that supplies a power supply voltage to each pixel 10a and the reset voltage source 34a. Further, commonality can be achieved between the power wire 40a and the reset voltage line 44a, so that wiring in the pixel array PA may be simplified. Similarly, commonality may be achieved between a voltage supply circuit (not illustrated in Fig. 3B) that supplies a power supply voltage to each pixel 10b and the reset voltage source 34b. Further, commonality can be achieved between the power wire 40b and the reset voltage line 44b, so that wiring in the pixel array PA may be simplified. Note, however, that using different voltages as the reset voltage Vr and the power supply voltage VDD of the signal detection circuits 14a and 14b allows more flexibility in control of the imaging device 100.

### [Device Structure of Pixels]

Next, a cross-section structure of pixels of the imaging device 100 according to the present embodiment is described.

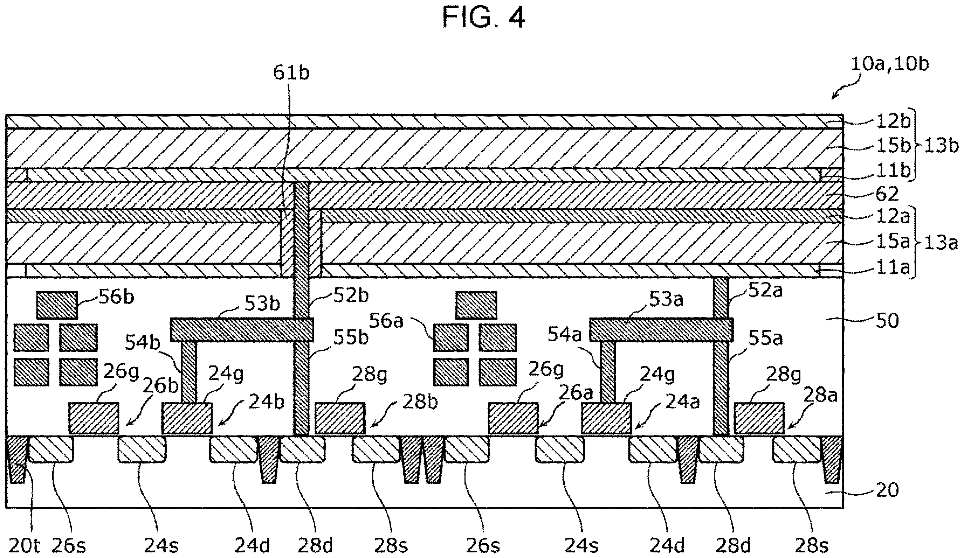

Fig. 4 is a cross-sectional view schematically showing an exemplary cross-section structure of pixels 10a and 10b according to the embodiment. In the configuration illustrated in Fig. 4, the aforementioned signal detection transistors 24a and 24b, address transistors 26a and 26b, and reset transistors 28a and 28b are formed in the semiconductor substrate 20. The semiconductor substrate 20 is not limited to a substrate made entirely of a semiconductor. The semiconductor substrate 20 may be an insulating substrate having a semiconductor layer covering a surface at which a photosensitive region is formed. Further, the semiconductor substrate 20 may have a plurality of semiconductor layers so that the signal detection transistor 24a, the address transistor 26a, and the reset transistor 28a are formed in one semiconductor layer and the signal detection transistor 24b, the address transistor 26b, and the reset transistor 28b are formed in another semiconductor layer. An example is described here in which a P-type silicon (Si) substrate is used as the semiconductor substrate 20.

Further, in Fig. 4, an example is described in which a first photoelectric converter 13a and a second photoelectric converter 13b of the same size are placed in the same region overlying the semiconductor substrate 20 in a plan view.

The semiconductor substrate 20 has impurity regions 26s, 24s, 24d, 28d, and 28s and a device isolation region 20t that provides electrical isolation between pixels. The impurity regions 26s, 24s, 24d, 28d, and 28s here are N-type regions. Further, the device isolation region 20t is also provided between the impurity region 24d and the impurity region 28d. The device isolation region 20t is formed, for example, by performing ion implantation of an acceptor under predetermined implantation conditions.

The impurity regions 26s, 24s, 24d, 28d, and 28s are for example diffusion layers formed in the semiconductor substrate 20. As schematically shown in Fig. 4, the signal detection transistors 24a and 24b each include the impurity regions 24s and 24d and a gate electrode 24g. The gate electrode 24g is made of a conducting material. The conducting material is for example polysilicon rendered conductive by being doped with an impurity, but may be a metal material. The impurity region 24s functions, for example, as source regions of the signal detection transistors 24a and 24b. The impurity region 24d functions, for example, as drain regions of the signal detection transistors 24a and 24b. The signal detection transistors 24a and 24b have their channel regions formed between the impurity regions 24s and 24d.

Similarly, the address transistors 26a and 26b each include the impurity regions 26s and 24s and a gate electrode 26g connected to the address control line 46a or 46b (see Figs. 3A and 3B), which is not illustrated in Fig. 4. The gate electrode 26g is made of a conducting material. The conducting material is for example polysilicon rendered conductive by being doped with an impurity, but may be a metal material. In this example, the signal detection transistor 24a and the address transistor 26a are electrically connected to each other by sharing the impurity region 24s. Similarly, the signal detection transistor 24b and the address transistor 26b are electrically connected to each other by sharing the impurity region 24s. The impurity region 26s functions, for example, as source regions of the address transistors 26a and 26b. The impurity region 26s has a connection to the vertical signal line 47a or 47b (see Figs. 3A and 3B), which is not illustrated in Fig. 4.

The reset transistors 28a and 28b each include the impurity regions 28d and 28s and a gate electrode 28g connected to the reset control line 48a or 48b (see Figs. 3A and 3B), which is not illustrated in Fig. 4. The gate electrode 28g is made of a conducting material. The conducting material is for example polysilicon rendered conductive by being doped with an impurity, but may be a metal material. The impurity region 28s functions, for example, as source regions of the reset transistors 28a and 28b. The impurity region 28s has a connection to the reset voltage line 44a or 44b (see Figs. 3A and 3B), which is not illustrated in Fig. 4. The impurity region 28d functions, for example, as drain regions of the reset transistors 28a and 28b.

An interlayer insulating layer 50 is placed over the semiconductor substrate 20 so as to cover the signal detection transistors 24a and 24b, the address transistors 26a and 26b, and the reset transistors 28a and 28b. The interlayer insulating layer 50 is made, for example, of an insulating material such as silicon oxide. As shown in Fig. 4, wiring layers 56a and 56b may be placed in the interlayer insulating layer 50. The wiring layers 56a and 56b are made, for example, of a metal such as copper. The wiring layer 56a may for example include a wire such as the aforementioned vertical signal lines 47a as part thereof. The wiring layer 56b may for example include a wire such as the aforementioned vertical signal lines 47b as part thereof. The number of insulating layers in the interlayer insulating layer 50 and the numbers of layers included in the wiring layers 56a and 56b placed in the interlayer insulating layer 50 may be arbitrarily set and are not limited to the example shown in Fig. 4.

The aforementioned first photoelectric converter 13a and the aforementioned second photoelectric converter 13b are placed over the interlayer insulating layer 50. In other words, in the present embodiment, the plurality of pixels 10a and the plurality of pixels 10b, which constitute the pixel array PA (see Figs. 3A and 3B), are formed in the semiconductor substrate 20 and over the semiconductor substrate 20. The plurality of pixels 10a and 10b, which are arrayed two-dimensionally over the semiconductor substrate 20, form a photosensitive region. The photosensitive region is also called "pixel region". The distance between adjacent two pixels 10a and the distance between adjacent two pixels 10b may each be approximately 2 µm. The distance between adjacent two pixels is also called "pixel pitch".

In the present embodiment, light falls on the first photoelectric converter 13a and the second photoelectric converter 13b from above the first photoelectric converter 13a and the second photoelectric converter 13b, i.e. from a side opposite to the semiconductor substrate 20.

The first photoelectric converter 13a includes a pixel electrode 11a serving as an example of the first pixel electrode, a counter electrode 12a serving as an example of the first counter electrode, and a photoelectric conversion layer 15a serving as an example of the first photoelectric conversion layer placed between the pixel electrode 11a and the counter electrode 12a. In this example, the counter electrode 12a and the photoelectric conversion layer 15a are formed across the plurality of pixels 10a. On the other hand, the pixel electrode 11a is provided for each pixel 10a and, by being spatially isolated from the pixel electrode 1 1a of an adjacent pixel 10a, is electrically isolated from the pixel electrode 1 1a of the adjacent pixel 10a.

The second photoelectric converter 13b includes a pixel electrode 11b serving as an example of the second pixel electrode, a counter electrode 12b serving as an example of the second counter electrode, and a photoelectric conversion layer 15b serving as an example of the second photoelectric conversion layer placed between the pixel electrode 11b and the counter electrode 12b. In this example, the counter electrode 12b and the photoelectric conversion layer 15b are formed across the plurality of pixels 10b. On the other hand, the pixel electrode 11b is provided for each pixel 10b and, by being spatially isolated from the pixel electrode 11b of an adjacent pixel 10b, is electrically isolated from the pixel electrode 11b of the adjacent pixel 10b.

The second photoelectric converter 13b is stacked above the first photoelectric converter 13a via an insulating layer 62. On the first photoelectric converter 13a, light having passed through the second photoelectric converter 13b and the insulating layer 62 falls. The second photoelectric converter 13b and the insulating layer 62 allow passage of at least part of light of wavelengths to which the first photoelectric converter 13a has sensitivity. Although the first photoelectric converter 13a and the second photoelectric converter 13b are electrically insulated from each other by the insulating layer 62, a change in a voltage that is applied to one of the first photoelectric converter 13a and the second photoelectric converter 13b causes a capacitance coupling that affects the capacitance of a charge storage region connected to the other photoelectric converter. In the imaging device 100, switching of the voltage that the voltage supply circuit 32a applies to the first photoelectric converter 13a and switching of the voltage that the voltage supply circuit 32b applies to the second photoelectric converter 13b are performed at appropriate timings, so that image quality degradation due to the influence of such a capacitance coupling can be reduced. Operation of the imaging device 100 will be described in detail later.

Above the second photoelectric converter 13b, a sealing layer, a color filter, a microlens, or other components may be further provided.

The pixel electrode 11a is an electrode for reading out signal charge generated by the first photoelectric converter 13a. There is at least one pixel electrode 11a for each pixel 10a. The pixel electrode 11a is electrically connected to the gate electrode 24g of the signal detection transistor 24a and the impurity region 28d. The pixel electrode 11b is an electrode for reading out signal charge generated by the second photoelectric converter 13b. There is at least one pixel electrode 11b for each pixel 10b. The pixel electrode 11b is electrically connected to the gate electrode 24g of the signal detection transistor 24b and the impurity region 28d. Further, the pixel electrode 11b is placed on a side of the photoelectric conversion layer 15b that faces the first photoelectric converter 13a.

The counter electrode 12a is placed opposite the pixel electrode 11a with the photoelectric conversion layer 15a sandwiched therebetween. The counter electrode 12a is placed, for example, on a side of the photoelectric conversion layer 15a on which light falls. Accordingly, on the photoelectric conversion layer 15a, light having passed through the counter electrode 12a falls. Further, the counter electrode 12a is placed, for example, on a side of the photoelectric conversion layer 15a that faces the second photoelectric converter 13b. Therefore, the first photoelectric converter 13a and the second photoelectric converter 13b are stacked so that the counter electrode 12a and the pixel electrode 11b face each other. The counter electrode 12a and the pixel electrode 11b are adjacent to each other via the insulating layer 62.

The counter electrode 12b is placed opposite the pixel electrode 11b with the photoelectric conversion layer 15b sandwiched therebetween. The counter electrode 12b is placed, for example, on a side of the photoelectric conversion layer 15b on which light falls. Accordingly, on the photoelectric conversion layer 15b, light having passed through the counter electrode 12b falls.

The pixel electrode 11b, the counter electrode 12a, and the counter electrode 12b are for example transparent electrodes made of a transparent conducting material. The term "transparent" herein means transmitting at least part of light in a wavelength range to be detected, and it is not essential to transmit light across the whole wavelength range of visible light. For example, the counter electrode 12b allows passage of at least part of light of wavelengths to which the first photoelectric converter 13a has sensitivity and at least part of light of wavelengths to which the second photoelectric converter 13b has sensitivity. Further, for example, the pixel electrode 11b and the counter electrode 12a allow passage of at least part of light of wavelengths to which the first photoelectric converter 13a has sensitivity.

The transparent electrodes may be made, for example, of a transparent conducting oxide (TCO) such as ITO, IZO, AZO, FTO, SnO₂, TiO₂, or ZnO₂.

The pixel electrode 11a is made of a conducting material. The conducting material is for example a metal such as aluminum or copper, a metal nitride, or polysilicon rendered conductive by being doped with an impurity.

The pixel electrode 11a may be a light-blocking electrode. For example, a sufficient light blocking effect may be achieved by forming, as the pixel electrode 1 1a, a TaN electrode whose thickness is 100 nm. When the pixel electrode 11a is a light-blocking electrode, light having passed through the photoelectric conversion layer 15a may be inhibited from falling on the channel region or impurity regions of a transistor formed in the semiconductor substrate 20 (in this example, at least any of the signal detection transistors 24a and 24b, the address transistors 26a and 26b, and the reset transistors 28a and 28b). The aforementioned wiring layers 56a and 56b may be utilized to form light-blocking films in the interlayer insulating layer 50. By inhibiting light from falling on the channel region of a transistor formed in the semiconductor substrate 20, a shift in the characteristic of the transistor (e.g. a fluctuation in threshold voltage) or other changes may be inhibited. Further, by inhibiting light from falling on an impurity region formed in the semiconductor substrate 20, noise contamination by unintended photoelectric conversion in the impurity region may be inhibited. Thus, inhibiting light from falling on the semiconductor substrate 20 contributes to improvement in reliability of the imaging device 100. t should be noted that the pixel electrode 11a may be a transparent electrode.

It should be noted that the pixel electrode 11a and the counter electrode 12a may swap with each other the positions where they are in when they are placed as shown in Fig. 4. In this case, the pixel electrode 11a is a transparent electrode, and the counter electrode 12a does not need to be a transparent electrode, provided the counter electrode 12a is made of a conducting material. Further, in this case, a plug 52a is disposed to penetrate the counter electrode 12a and the photoelectric conversion layer 15a.

Further, the pixel electrode 11b and the counter electrode 12b may swap with each other the positions where they are in when they are placed as shown in Fig. 4. In this case, a plug 52b is disposed to penetrate the counter electrode 12b and the photoelectric conversion layer 15b.

Further, the first photoelectric converter 13a and the second photoelectric converter 13b may swap with each other the positions where they are in when they are placed as shown in Fig. 4.

The photoelectric conversion layers 15a and 15b each generate a hole-electron pair upon receiving incident light. The photoelectric conversion layers 15a and 15b are each made, for example, of an organic material. Further, the photoelectric conversion layers 15a and 15b may each have a structure in which a plurality of layers are stacked. Specific examples of the materials of which the photoelectric conversion layers 15a and 15b are made will be described later.

As described with reference to Fig. 3A, the counter electrode 12a has a connection to the sensitivity control line 42a, which is connected to the voltage supply circuit 32a. Further, in this example, the counter electrode 12a is formed across the plurality of pixels 10a. This enables the voltage supply circuit 32a to apply a sensitivity control voltage of desired magnitude across the plurality of pixels 10a en bloc via the sensitivity control line 42a. Further, as described with reference to Fig. 3B, the counter electrode 12b has a connection to the sensitivity control line 42b, which is connected to the voltage supply circuit 32b. Further, in this example, the counter electrode 12b is formed across the plurality of pixels 10b. This enables the voltage supply circuit 32b to apply a sensitivity control voltage of desired magnitude across the plurality of pixels 10b en bloc via the sensitivity control line 42b. As long as a sensitivity control voltage of desired magnitude can be applied from the voltage supply circuit 32a or 32b, at least one of the counter electrodes 12a and 12b may be provided separately for each of the pixels 10a or 10b. Similarly, at least one of the photoelectric conversion layers 15a and 15b may be provided separately for each of the pixels 10a or 10b.

As will be described in detail later, the voltage supply circuits 32a and 32b each supply, to the counter electrode 12a or 12b, voltages differing from each other between an exposure period and a non-exposure period. The term "exposure period" herein means a period in which to store, in charge storage regions or other regions, either positive or negative charge (signal charge) generated by photoelectric conversion of the first photoelectric converter 13a and the second photoelectric converter 13b, and may be called "charge storage period". Further, the term "non-exposure period" means a period during operation of the imaging device excluding an exposure period. It should be noted that the "non-exposure period" is not limited to a period during which light is blocked from falling on the first photoelectric converter 13a or the second photoelectric converter 13b, but may include a period during which the first photoelectric converter 13a or the second photoelectric converter 13b is illuminated with light. Further, the "non-exposure period" includes a period in which signal charge is unintentionally stored in a charge storage region due to the occurrence of parasitic sensitivity.

Further, the "non-exposure period" includes a "readout period" and a "reset period". The "readout period" is a period in which signals corresponding to the amounts of signal charge generated by the first photoelectric converter 13a and the second photoelectric converter 13b (i.e. the amounts of signal charge stored in the charge storage regions) are read out by the signal detection circuits 14a and 14b, respectively. The "reset period" is a period in which to reset the potentials of the charge storage regions in which to store the signal charge generated by the first photoelectric converter 13a and the second photoelectric converter 13b. Specifically, in the "reset period", the potentials of the charge storage regions are reset to the reset voltage Vr.

Further, in the present embodiment, the "exposure period", the "non-exposure period", the "readout period", and the "reset period" are defined for each of the pixels 10a and 10b. Since, in the pixel 10a, a signal corresponding to the amount of signal charge generated by the first photoelectric converter 13a is read out, the "exposure period", the "non-exposure period", the "readout period", and the "reset period" of the pixel 10a can also be said to be an "exposure period", a "non-exposure period", a "readout period", and a "reset period" of the first photoelectric converter 13a. Since, in the pixel 10b, a signal corresponding to the amount of signal charge generated by the second photoelectric converter 13b is read out, the "exposure period", the "non-exposure period", the "readout period", and the "reset period" of the pixel 10b can also be said to be an "exposure period", a "non-exposure period", a "readout period", and a "reset period" of the second photoelectric converter 13b. Each of these periods will be described in detail later.

By controlling the potential of the counter electrode 12a in relation to the potential of the pixel electrode 11a, either the hole or electron of a hole-electron pair generated in the photoelectric conversion layer 15a by photoelectric conversion can be collected as signal charge by the pixel electrode 11a. For example, in a case where the hole is utilized as signal charge, the hole can be selectively collected by the pixel electrode 11a by making the counter electrode 12a higher in potential than the pixel electrode 11a. Further, by controlling the potential of the counter electrode 12b in relation to the potential of the pixel electrode 11b, either the hole or electron of a hole-electron pair generated in the photoelectric conversion layer 15b by photoelectric conversion can be collected as signal charge by the pixel electrode 11b. For example, in a case where the hole is utilized as signal charge, the hole can be selectively collected by the pixel electrode 11b by making the counter electrode 12b higher in potential than the pixel electrode 11b. The following illustrates a case where the hole is utilized as signal charge. Of course, it is also possible to utilize the electron as signal charge. In this case, the counter electrode 12a is made lower in potential than the pixel electrode 11a, and the counter electrode 12b is made lower in potential than the pixel electrode 11b.

In the presence of the application of an appropriate bias voltage between the counter electrode 12a and the pixel electrode 11a, the pixel electrode 11a, which faces the counter electrode 12a, collects either positive or negative charge generated by photoelectric conversion in the photoelectric conversion layer 15a. Further, in the presence of the application of an appropriate bias voltage between the counter electrode 12b and the pixel electrode 11b, the pixel electrode 11b, which faces the counter electrode 12b, collects either positive or negative charge generated by photoelectric conversion in the photoelectric conversion layer 15b.

In the imaging device 100, the insulating layer 62 is provided between the first photoelectric converter 13a and the second photoelectric converter 13b. The insulating layer 62 electrically isolates the first photoelectric converter 13a and the second photoelectric converter 13b from each other. In the example shown in Fig. 4, the pixel electrode 11a, the photoelectric conversion layer 15a, the counter electrode 12a, the insulating layer 62, the pixel electrode 11b, the photoelectric conversion layer 15b, and the counter electrode 12b are stacked in this order from below. The insulating layer 62 is made of a transparent insulating material. For example, the insulating layer 62 allows passage of at least part of light of wavelengths to which the first photoelectric converter 13a has sensitivity. The insulating layer 62 may be made, for example, of silicon oxynitride, aluminum oxide, or other materials.

As schematically shown in Fig. 4, the pixel electrode 11a is connected to the gate electrode 24g of the signal detection transistor 24a via the plug 52a, a wire 53a, and a contact plug 54a. In other words, the gate of the signal detection transistor 24a has an electrical connection to the pixel electrode 11a. The plug 52a, the wire 53a, and the contact plug 54a constitute at least part of the charge storage node 41a (see Fig. 3A) between the signal detection transistor 24a and the first photoelectric converter 13a. The wire 53a may be part of the wiring layer 56a. Further, the pixel electrode 11a is also connected to the impurity region 28d of the reset transistor 28a via the wire 53a and a contact plug 55a. In the configuration illustrated in Fig. 4, the gate electrode 24g of the signal detection transistor 24a, the plug 52a, the wire 53a, the contact plugs 54a and 55a, and the impurity region 28d, which is one of the source region and the drain region of the reset transistor 28a, function as a charge storage region of the pixel 10a in which to store signal charge collected by the pixel electrode 11a.

Further, the pixel electrode 11b is connected to the gate electrode 24g of the signal detection transistor 24b via the plug 52b, a wire 53b, and a contact plug 54b. In other words, the gate of the signal detection transistor 24b has an electrical connection to the pixel electrode 11b. The plug 52b penetrates the first photoelectric converter 13a and the insulating layer 62. The plug 52b, the wire 53b, and the contact plug 54b constitute at least part of the charge storage node 41b (see Fig. 3B) between the signal detection transistor 24b and the second photoelectric converter 13b. The wire 53b may be part of the wiring layer 56b. Further, the pixel electrode 11b is also connected to the impurity region 28d of the reset transistor 28b via the wire 53b and a contact plug 55b. In the configuration illustrated in Fig. 4, the gate electrode 24g of the signal detection transistor 24b, the plug 52b, the wire 53b, the contact plugs 54b and 55b, and the impurity region 28d, which is one of the source region and the drain region of the reset transistor 28b, function as a charge storage region of the pixel 10b in which to store signal charge collected by the pixel electrode 11b.

The plugs 52a and 52b, the wires 53a and 53b, and the contact plugs 54a, 54b, 55a, and 55b are each made of a conducting material. For example, the plugs 52a and 52b and the wires 53a and 53b are each made of a metal such as copper. Further, for example, the contact plugs 54a, 54b, 55a, and 55b are each made of polysilicon rendered conductive by being doped with an impurity. It should be noted that the plugs 52a and 52b, the wires 53a and 53b, and the contact plugs 54a, 54b, 55a, and 55b may be made of the same material as one another or may be made of different materials from one another.

Further, an insulating coating 61b is formed around the plug 52b. The insulating coating 61b is located between the plug 52b and the first photoelectric converter 13a. The plug 52b and the first photoelectric converter 13a are not in contact with each other but electrically insulated from each other by the insulating coating 61b. The insulating coating 61b is made, for example, an insulating material such as silicon oxide or silicon nitride.

The collection of signal charge by the pixel electrode 11a causes a voltage corresponding to the amount of signal charge stored in the charge storage region of the pixel 10a to be applied to the gate of the signal detection transistor 24a. The signal detection transistor 24a amplifies this voltage. The voltage amplified by the signal detection transistor 24a is selectively read out as a signal voltage via the address transistor 26a. Further, the collection of signal charge by the pixel electrode 11b causes a voltage corresponding to the amount of signal charge stored in the charge storage region of the pixel 10b to be applied to the gate of the signal detection transistor 24b. The signal detection transistor 24b amplifies this voltage. The voltage amplified by the signal detection transistor 24b is selectively read out as a signal voltage via the address transistor 26b.

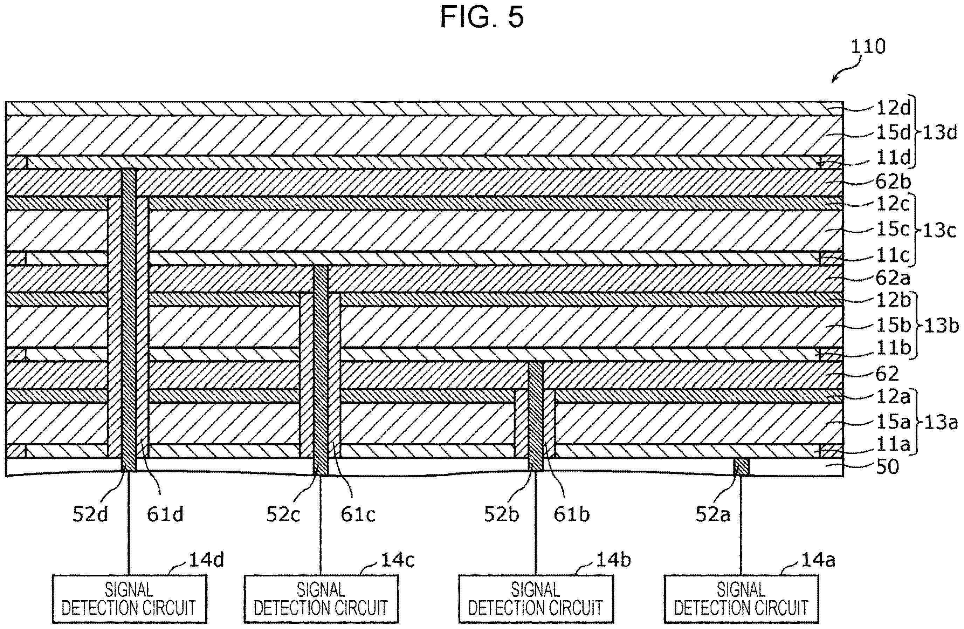

It should be noted that the number of photoelectric converters that the imaging device 100 includes is not limited to particular numbers, provided it is larger than or equal to 2. An imaging device according to the present embodiment may include three or more photoelectric converters. Fig. 5 is a schematic view showing a configuration of another imaging device according to the present embodiment. Fig. 5 schematically shows photoelectric converters and signal detection circuits that the imaging device includes, and omits to illustrate the other components. Specifically, Fig. 5 illustrates a portion of a pixel structure situated above an upper end portion of the interlayer insulating layer 50 and connections between the photoelectric converters and the signal detection circuits.

As shown in Fig. 5, the imaging device 110 differs from the imaging device 100 in that the imaging device 110 further includes photoelectric converters 13c and 13d and signal detection circuits 14c and 14d. Further, although not illustrated, as is the case with the imaging device 100 described with reference to Figs. 3A to 4, the imaging device 110 also includes reset transistors for resetting the photoelectric converters 13c and 13d and peripheral circuits for acquiring images based on signal charge generated by the photoelectric converters 13c and 13d. Each of the photoelectric converters 13c and 13d is an example of the third photoelectric converter. Each of the signal detection circuits 14c and 14d is an example of the third signal detection circuit. The photoelectric converter 13c and the signal detection circuit 14c may constitute part of the pixel 10a or the pixel 10b, or may constitute at least part of another pixel differing from the pixel 10a and the pixel 10b. Further, the photoelectric converter 13d and the signal detection circuit 14d may constitute part of the pixel 10a or the pixel 10b, or may constitute at least part of another pixel differing from the pixel 10a and the pixel 10b.

The photoelectric converters 13c and 13d are stacked above the first photoelectric converter 13a and the second photoelectric converter 13b. Specifically, in the imaging device 110, the first photoelectric converter 13a, the second photoelectric converter 13b, the photoelectric converter 13c, and the photoelectric converter 13d are stacked in this order from below. It should be noted that the photoelectric converters may be stacked in any order.

The first photoelectric converter 13a, the second photoelectric converter 13b, the photoelectric converter 13c, and the photoelectric converter 13d for example have sensitivity to wavelength ranges differing from one another.

An insulating layer 62a is placed between the second photoelectric converter 13b and the photoelectric converter 13c. The second photoelectric converter 13b and the photoelectric converter 13c are electrically insulated from each other by the insulating layer 62a.

An insulating layer 62b is placed between the photoelectric converter 13c and the photoelectric converter 13d. The photoelectric converter 13c and the photoelectric converter 13d are electrically insulated from each other by the insulating layer 62b.

The photoelectric converter 13c has a pixel electrode 11c, a counter electrode 12c placed opposite the pixel electrode 11c, and a photoelectric conversion layer 15c placed between the pixel electrode 11c and the counter electrode 12c.

The pixel electrode 11c is connected to the signal detection circuit 14c via a plug 52c or other components. The plug 52c penetrates the first photoelectric converter 13a, the second photoelectric converter 13b, and the insulating layers 62 and 62a. An insulating coating 61c is formed around the plug 52c. The insulating coating 61c is located between the plug 52c and the first photoelectric converter 13a and between the plug 52c and the second photoelectric converter 13b.

The photoelectric converter 13d has a pixel electrode 11d, a counter electrode 12d placed opposite the pixel electrode 11d, and a photoelectric conversion layer 15d placed between the pixel electrode 11d and the counter electrode 12d.

The pixel electrode 11d is connected to the signal detection circuit 14d via a plug 52d or other components. The plug 52d penetrates the first photoelectric converter 13a, the second photoelectric converter 13b, the photoelectric converter 13c, and the insulating layers 62, 62a, and 62b. An insulating coating 61d is formed around the plug 52d. The insulating coating 61d is located between the plug 52d and the first photoelectric converter 13a, between the plug 52d and the second photoelectric converter 13b, and between the plug 52d and the photoelectric converter 13c.

Thus, even in a case where the imaging device 110 includes three or more photoelectric converters, image quality degradation can be reduced as in the case of the imaging device 100 by making appropriate the timing of switching of a voltage that is supplied to each photoelectric converter, although a change in the voltage of each photoelectric converter causes a capacitance coupling that affects photoelectric converters other than the photoelectric converter subjected to the voltage change, signal detection circuits connected to the photoelectric converters, and the potentials of charge storage regions connected to the photoelectric converters.

Further, the imaging device 110 makes it possible to increase the number of types of signal that can be acquired by each photoelectric converter. This makes it possible to easily acquire a color image or other images by adjusting wavelengths to which each photoelectric converter has sensitivity.

### [Example Configurations of Photoelectric Conversion Layers]

Next, the photoelectric conversion layers 15a and 15b according to the present embodiment are described in detail.

As mentioned above, in the first photoelectric converter 13a, by illuminating the photoelectric conversion layer 15a with light and applying a bias voltage between the pixel electrode 11a and the counter electrode 12a, either positive or negative charge generated by photoelectric conversion is collected by the pixel electrode 11a, and the electric charge thus collected can be stored in the charge storage region. By using, in the first photoelectric converter 13a, a photoelectric conversion layer 15a that exhibits a photocurrent characteristic such as that described below and reducing the potential difference between the pixel electrode 11a and the counter electrode 12a to a certain degree, the signal charge already stored in the charge storage region can be inhibited from migrating to the counter electrode 12a via the photoelectric conversion layer 15a. Furthermore, further storage of signal charge into the charge storage region after the reduction of the potential difference may be inhibited. That is, by controlling the magnitude of a bias voltage that is applied to the photoelectric conversion layer 15a, a global shutter function may be achieved without separately providing each of the plurality of pixels with an element such as a transfer transistor as in the case of a technology described in PTL 4. As for the second photoelectric converter 13b too, a global shutter function may be achieved by operation that is similar to that of the first photoelectric converter 13a. An example of operation in the imaging device 100 will be described later.

The photoelectric conversion layers 15a and 15b each contain, for example, a semiconductor material. In the present embodiment, for example, an organic semiconductor material is used as the semiconductor material.

At least one of the photoelectric conversion layers 15a and 15b contains, for example, tin naphthalocyanine represented by general formula (1) below. In the following, the tin naphthalocyanine represented by general formula (1) below is sometimes simply called "tin naphthalocyanine".

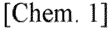

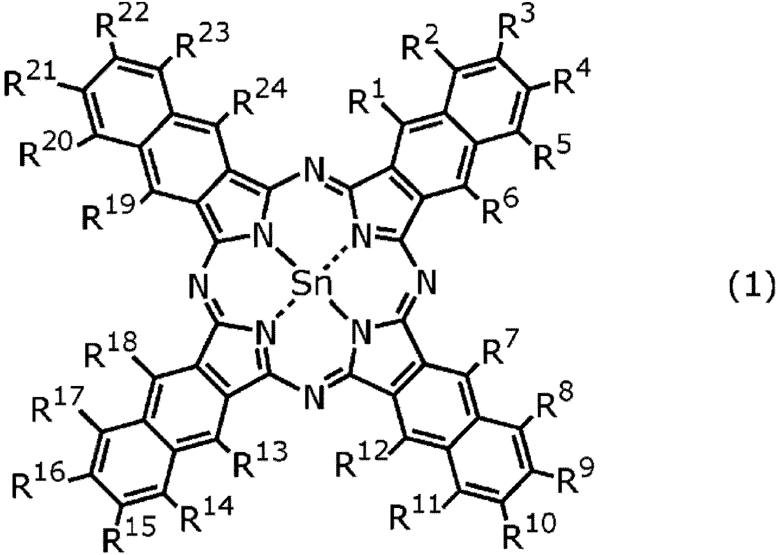

In general formula (1), R¹ to R²⁴ each independently represent a hydrogen atom or a substituent. The substituent is not limited to particular substituents. The substituent may be a deuterium atom, a halogen atom, an alkyl group (including a cycloalkyl group, a bicycloalkyl group, and a tricycloalkyl group), an alkenyl group (including a cycloalkenyl group and a bicycloalkenyl group), an alkynyl group, an aryl group, a heterocyclic group, a cyano group, a hydroxy group, a nitro group, a carboxy group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an ammonio group, an acylamino group, an aminocarbonylamino group, an alkoxycarbonylamino group, an aryloxycarbonylamino group, a sulfamoylamino group, an alkylsulfonylamino group, an arylsulfonylamino group, a mercapto group, an alkylthio group, an arylthio group, a heterocyclic thio group, a sulfamoyl group, a sulfo group, an alkylsulfinyl group, an arylsulfinyl group, an alkylsulfonyl group, an arylsulfonyl group, an acyl group, an aryloxycarbonyl group, an alkoxycarbonyl group, a carbamoyl group, an arylazo group, a heterocyclic azo group, an imide group, a phosphino group, a phosphinyl group, a phosphinyloxy group, a phosphinylamino group, a phosphono group, a silyl group, a hydrazino group, a ureide group, a boronic acid group (-B(OH)₂), a phosphate group (-OPO(OH)₂), a sulfato group (-OSO₃H), or other publicly-known substituents.

As the tin naphthalocyanine represented by general formula (1) above, a commercially available product may be used. Alternatively, for example, as disclosed in PTL 5, the tin naphthalocyanine represented by general formula (1) above may be synthesized with a naphthalene derivative represented by general formula (2) below as a starting material. R²⁵ to R³⁰ in general formula (2) may be substituents that are similar to R¹ to R²⁴ in general formula (1).

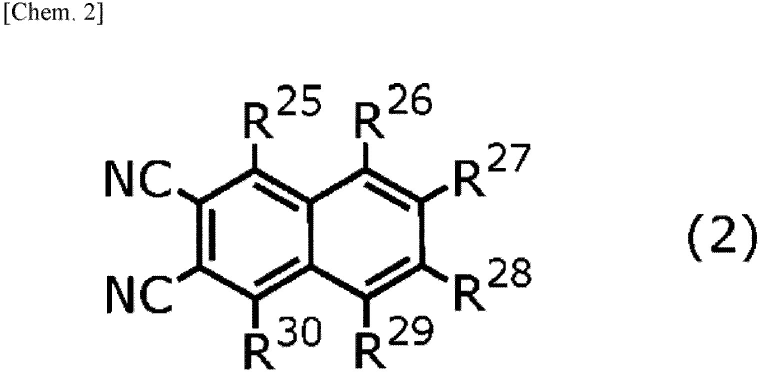

In the tin naphthalocyanine represented by general formula (1) above, eight or more of R¹ to R²⁴ may be hydrogen atoms or deuterium atoms, sixteen of more of R¹ to R²⁴ may be hydrogen atoms or deuterium atoms, or all of R¹ to R²⁴ may be hydrogen atoms or deuterium atoms from the point of view of ease of control of a molecular aggregation state. Furthermore, tin naphthalocyanine represented by general formula (3) below is advantageous in view of ease of synthesis.

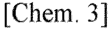

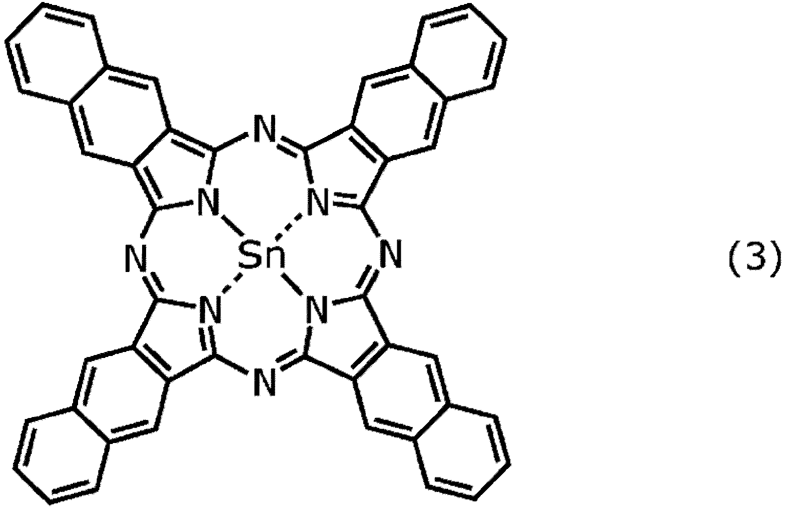

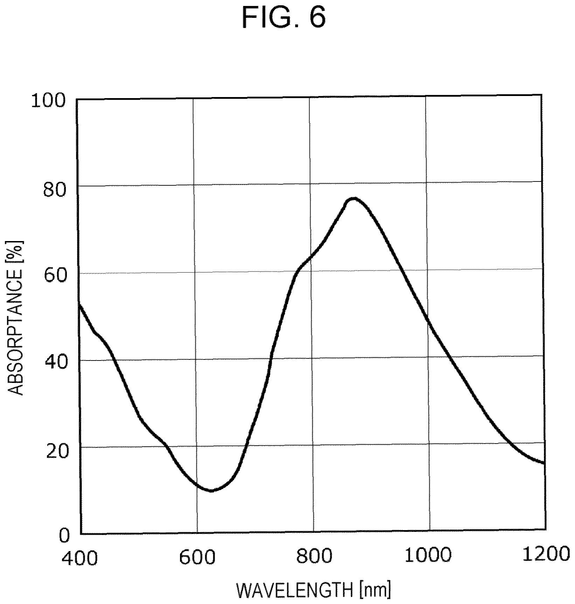

The tin naphthalocyanine represented by general formula (1) above has absorption in a wavelength range of approximately 200 nm to 1100 nm. The tin naphthalocyanine represented by general formula (3) above has an absorption peak at a wavelength of approximately 870 nm as shown in Fig. 6. Fig. 6 is a diagram showing an example of an absorbing spectrum in a photoelectric conversion layer containing the tin naphthalocyanine represented by general formula (3) above. It should be noted that the measurement of the absorption spectrum involves the use of a sample having a photoelectric conversion layer (30 nm thick) stacked over a quartz substrate.

As can be seen from Fig. 6, a photoelectric conversion layer made of a material containing tin naphthalocyanine has absorption in the near-infrared wavelength region. That is, by selecting a material containing tin naphthalocyanine as a material of which at least one of the photoelectric conversion layer 15a and the photoelectric conversion layer 15b is made, an optical sensor capable of detecting near-infrared radiation may be achieved, for example. Further, instead of tin naphthalocyanine, a naphthalocyanine derivative whose central metal is not tin but silicon or another metal such as germanium may be used. Further, axial ligands may coordinate to the central metal of the naphthalocyanine derivative.

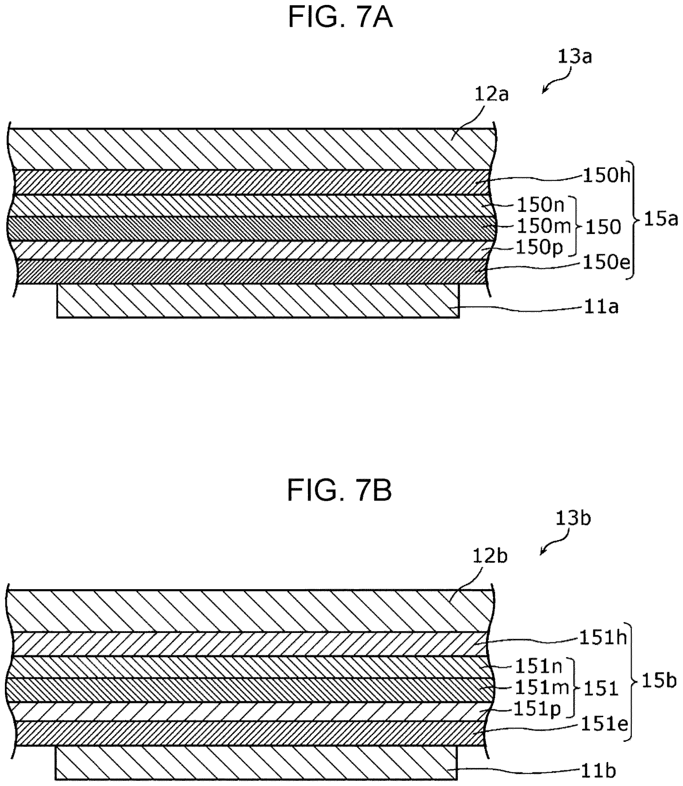

Fig. 7A is a cross-sectional view schematically showing an example of a configuration of the photoelectric conversion layer 15a in the first photoelectric converter 13a. Fig. 7B is a cross-sectional view schematically showing an example of a configuration of the photoelectric conversion layer 15b in the second photoelectric converter 13b. As shown in Figs. 7A and 7B, the photoelectric conversion layer 15a and the photoelectric conversion layer 15b have similar stack configurations.

As shown in Fig. 7A, the photoelectric conversion layer 15a has, for example, a hole blocking layer 150h, a photoelectric conversion structure 150, and an electron blocking layer 150e. The hole blocking layer 150h is placed between the photoelectric conversion structure 150 and the counter electrode 12a. The electron blocking layer 150e is placed between the photoelectric conversion structure 150 and the pixel electrode 11a.

As shown in Fig. 7B, the photoelectric conversion layer 15b has, for example, a hole blocking layer 151h, a photoelectric conversion structure 151, and an electron blocking layer 151e. The hole blocking layer 151h is placed between the photoelectric conversion structure 151 and the counter electrode 12b. The electron blocking layer 151e is placed between the photoelectric conversion structure 151 and the pixel electrode 11b.

The photoelectric conversion structures 150 and 151 each contain at least one of a p-type semiconductor and an n-type semiconductor.

As shown in Fig. 7A, the photoelectric conversion structure 150 has, for example, a p-type semiconductor layer 150p, an n-type semiconductor layer 150n, and a mixed layer 150m sandwiched between the p-type semiconductor layer 150p and the n-type semiconductor layer 150n. The p-type semiconductor layer 150p is placed between the electron blocking layer 150e and the mixed layer 150m and has a photoelectric conversion and/or hole transport function. The n-type semiconductor layer 150n is placed between the hole blocking layer 150h and the mixed layer 150m and has a photoelectric conversion and/or electron transport function. Further, as shown in Fig. 7B, the photoelectric conversion structure 151 has, for example, a p-type semiconductor layer 151p, an n-type semiconductor layer 151n, and a mixed layer 151m sandwiched between the p-type semiconductor layer 151p and the n-type semiconductor layer 151n. The p-type semiconductor layer 151p is placed between the electron blocking layer 151e and the mixed layer 151m and has a photoelectric conversion and/or hole transport function. The n-type semiconductor layer 151n is placed between the hole blocking layer 151h and the mixed layer 151m and has a photoelectric conversion and/or electron transport function.

As will be described later, the mixed layers 150m and 151m may each contain at least one of a p-type semiconductor and an n-type semiconductor.

The p-type semiconductor layers 150p and 151p each contain, for example, an organic p-type semiconductor. The n-type semiconductor layers 150n and 151n each contain, for example, an organic n-type semiconductor. Therefore, the photoelectric conversion structures 150 and 151 contain, for example, an organic photoelectric conversion material containing the tin naphthalocyanine represented by general formula (1) above, the organic p-type semiconductor, and the organic n-type semiconductor.

The organic p-type semiconductor is a donor organic semiconductor and, typified mainly by a hole transport organic compound, refers to an electron-donating organic compound. In more particular, the organic p-type semiconductor refers to an organic compound that is lower in ionization potential when two organic materials are used in contact with each other. Accordingly, it is possible to use any electron-donating organic compound as the donor organic compound. Usable examples include metal complexes having, as ligands, a triarylamine compound, a benzidine compound, a pyrazoline compound, a styrylamine compound, a hydrazone compound, a triphenylmethane compound, a carbazole compound, a polysilane compound, a thiophene compound, a phthalocyanine compound, naphthalocyanine compound, a subphthalocyanine compound, a cyanine compound, a merocyanine compound, an oxonol compound, a polyamine compound, an indole compound, a pyrrole compound, a pyrazole compound, a polyarylene compound, a condensed aromatic carbocyclic compound (naphthalene derivative, anthracene derivative, phenanthrene derivative, tetracene derivative, pyrene derivative, perylene derivative, fluoranthene derivative), and a nitrogen-containing heterocyclic compound. The donor organic semiconductor is not limited to this, and an organic material that is lower in ionization potential than an organic material used as the after-mentioned acceptor organic compound may be used as the donor organic semiconductor. The acceptor organic compound is also called "n-type organic compound". The aforementioned "tin naphthalocyanine" is an example of an organic p-type semiconductor material.

The organic n-type semiconductor is an acceptor organic semiconductor and, typified mainly by an electron transport organic compound, refers to an electron-accepting organic compound. In more particular, the organic n-type semiconductor refers to an organic compound that is higher in ionization potential when two organic compounds are used in contact with each other. Accordingly, it is possible to use any electron-accepting organic compound as the acceptor organic compound. Usable examples include metal complexes having, as ligands, a fullerene, a fullerene derivative, a condensed aromatic carbocyclic compound (naphthalene derivative, anthracene derivative, phenanthrene derivative, tetracene derivative, pyrene derivative, perylene derivative, fluoranthene derivative), a 5- to 7-membered heterocyclic compound containing a nitrogen atom, an oxygen atom, or a sulfur atom (such as pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole , benzothiazole, carbazole, purine, triazolopyridazine, triazolopyrimidine, tetrazaindene, oxadiazole, imidazopyridine, pyrrolidine, pyrrolopyridine, thiadiazolopyridine, dibenzazepine, or tribenzazepine), a polyarylene compound, a fluorene compound, a cyclopentadiene compound, a silyl compound, and a nitrogen-containing heterocyclic compound. The acceptor organic semiconductor is not limited to this, and as mentioned above, an organic material that is higher in electron affinity than an organic material used as the donor organic compound may be used as the acceptor organic semiconductor. The donor organic compound is also called "p-type organic compound".

The mixed layers 150m and 151m may each be, for example, a bulk heterojunction structure layer including an organic p-type semiconductor and an organic n-type semiconductor. In a case where the mixed layers 150m and 151m are formed as layers each having a bulk heterojunction structure, the tin naphthalocyanine represented by general formula (1) above may be used as the organic p-type semiconductor material. As the organic n-type semiconductor material, for example, a fullerene and/or a fullerene derivative may be used.

From the point of view of improving photoelectric conversion efficiency, the material constituting the p-type semiconductor layer 150p may be the same as the p-type semiconductor material contained in the mixed layer 150m. Further, the material constituting the p-type semiconductor layer 151p may be the same as the p-type semiconductor material contained in the mixed layer 151m. Similarly, the material constituting the n-type semiconductor layer 150n may be the same as the n-type semiconductor material contained in the mixed layer 150m. Further, the material constituting the n-type semiconductor layer 151n may be the same as the n-type semiconductor material contained in the mixed layer 151m. A bulk heterojunction structure is described in detail in PTL 6 (Japanese Patent No. 5553727), the entire contents of which are hereby incorporated by reference.

Using appropriate materials depending on the wavelength range to be detected makes it possible to achieve an imaging device having sensitivity to the desired wavelength range. It should be noted that the materials used in the photoelectric conversion layers 15a and 15b are not limited to organic semiconductor materials. At least one of the photoelectric conversion layers 15a and 15b may contain an inorganic semiconductor material such as amorphous silicon or a compound semiconductor as the p-type semiconductor and/or the n-type semiconductor. At least one of the photoelectric conversion layers 15a and 15b may include a layer made of an organic material and a layer made of an inorganic material.

While the foregoing has described a photoelectric conversion layer containing tin naphthalocyanine and having sensitivity to the near-infrared wavelength region, the materials contained in the photoelectric conversion layers 15a and 15b are not limited to photoelectric conversion materials for use in the near-infrared wavelength region. For example, by containing subphthalocyanine as the p-type semiconductor and containing a fullerene and/or a fullerene derivative as the n-type semiconductor, at least one of the photoelectric conversion layers 15a and 15b can be a photoelectric conversion layer having sensitivity to the visible light wavelength region. Further, by containing copper phthalocyanine as the p-type semiconductor and containing the C₆₀ fullerene as the n-type semiconductor, at least one of the photoelectric conversion layers 15a and 15b can be a photoelectric conversion layer having sensitivity to the ultraviolet wavelength region.

Further, the photoelectric conversion layers 15a and 15b are not limited in structure to the aforementioned examples. For example, the photoelectric conversion layer 15a does not need to include at least one of the hole blocking layer 150h, the electron blocking layer 150e, the p-type semiconductor layer 150p, and the n-type semiconductor layer 150n. Further, the photoelectric conversion layer 15b does not need to include at least one of the hole blocking layer 151h, the electron blocking layer 151e, the p-type semiconductor layer 151p, and the n-type semiconductor layer 151n.

### [Photocurrent Characteristics of Photoelectric Conversion Layers]

Next, the photocurrent characteristics of the photoelectric conversion layers 15a and 15b are described. While the following representatively describes the photocurrent characteristic of the photoelectric conversion layer 15a of the first photoelectric converter 13a, the photoelectric conversion layer 15b of the second photoelectric converter 13b may have a similar photocurrent characteristic. Therefore, the photocurrent characteristic of the photoelectric conversion layer 15b of the second photoelectric converter 13b too may be described by reading "constituent elements such as the first photoelectric converter 13a and peripheral circuits connected to the first photoelectric converter 13a in the following description" as "corresponding constituent elements such as the second photoelectric converter 13b and peripheral circuits connected to the second photoelectric converter 13b".

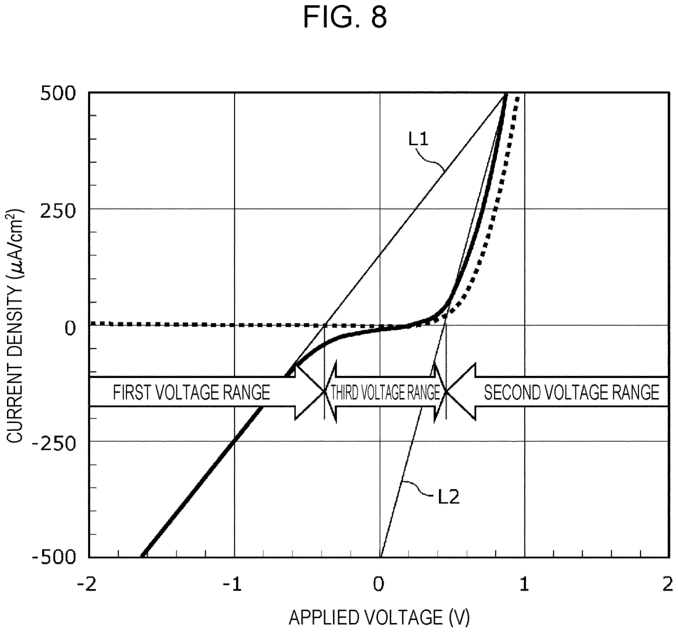

Fig. 8 is a graph showing an exemplary photocurrent characteristic of the photoelectric conversion layer 15a. In the graph of Fig. 8, the thick solid line indicates an exemplary current-voltage characteristic (I-V characteristic) of the photoelectric conversion layer 15a in a state of being illuminated with light. In Fig. 8, an example of an I-V characteristic of the photoelectric conversion layer 15a in a state of not being illuminated with light too is indicated by the thick dotted line. Although Fig. 8 illustrates an example in which a bulk heterojunction structure obtained by co-evaporation of tin naphthalocyanine and the C₆₀ fullerene is applied to the photoelectric conversion layer 15a, a combination of materials for expressing the illustrated I-V characteristic is not limited to particular combinations.

Fig. 8 shows a change in the density of a current that, under constant illuminance, flows between two principal surfaces of the photoelectric conversion layer 15a when a bias voltage that is applied between the two principal surfaces is changed. Forward and backward bias voltages are herein defined as follows. In a case where the photoelectric conversion layer 15a has a junction structure of a layered p-type semiconductor and a layered n-type semiconductor, a bias voltage that makes a layer of the p-type semiconductor layer higher in potential than a layer of the n-type semiconductor layer is defined as a forward bias voltage. On the other hand, a bias voltage that makes the layer of the p-type semiconductor layer lower in potential than the layer of the n-type semiconductor layer is defined as a backward bias voltage. In a case where the photoelectric conversion layer 15a has a bulk heterojunction structure, as schematically shown in Fig. 1 of the aforementioned Japanese Patent No. 5553727, more of the p-type semiconductor than the n-type semiconductor appears in one of two principal surfaces of the bulk heterojunction structure that faces an electrode, and more of the n-type semiconductor than the p-type semiconductor appears in the other principal surface. Accordingly, a bias voltage that makes the potential on the principal surface in which more of the p-type semiconductor than the n-type semiconductor appears higher than the potential on the principal surface in which more of the n-type semiconductor than the p-type semiconductor appears is defined as a forward bias voltage. In the present embodiment, for example, a voltage that makes the potential of the counter electrode 12a higher than the potential of the pixel electrode 11a is a backward bias voltage. On the other hand, a voltage that makes the potential of the counter electrode 12a lower than the potential of the pixel electrode 11a is a forward bias voltage.

As shown in Fig. 8, the photocurrent characteristic of the photoelectric conversion layer 15a is schematically characterized by three voltage ranges, namely first to third voltage ranges. The first voltage range is a range of backward bias voltages, and is a voltage range in which the absolute value of an output current density increases with an increase in backward bias voltage. The first voltage range may also be said to be a voltage range in which a photoelectric current increases with an increase in a bias voltage that is applied between the principal surfaces of the photoelectric conversion layer 15a. The second voltage range is a range of forward bias voltages, and is a voltage range in which the output current density increases with an increase in forward bias voltage. That is, the second voltage range is a voltage range in which a forward current increases with an increase in a bias voltage that is applied between the principal surfaces of the photoelectric conversion layer 15a. The third voltage range is a voltage range between the first voltage range and the second voltage range. Thus, the sensitivity of the first photoelectric converter 13a is able to be changed by switching of the bias voltage that the voltage supply circuit 32a applies to the photoelectric conversion layer 15a. This makes it possible to adjust sensitivity during imaging with the first photoelectric converter 13a simply by switching of the applied bias voltage.

For example, in a case where the applied bias voltage is switched between two voltage values in the first voltage range, the sensitivity of the first photoelectric converter 13a changes, as the absolute value of the output current density varies. Further, in a case where the applied bias voltage is switched between a voltage value of the first voltage range and a voltage value of the third voltage range, the sensitivity of the first photoelectric converter 13a changes in a similar fashion. Further, in this case, in the presence of the application of a bias voltage of a voltage value of the third voltage range, the sensitivity of the first photoelectric converter 13a is almost zero.

As in the case of the first photoelectric converter 13a, the sensitivity of the second photoelectric converter 13b is able to be changed by switching of a bias voltage that the voltage supply circuit 32b applies to the photoelectric conversion layer 15b.

The first to third voltage ranges may be distinguished from one another by the slopes of lines of the graph of the photocurrent characteristic when linear vertical and horizontal axes are used. In Fig. 8, the average slopes of lines of the graph in the first voltage range and the second voltage range are indicated by a thin solid line L1 and a thin solid line L2, respectively. As illustrated in Fig. 8, the rates of change in output current density in response to increases in bias voltage in the first voltage range, the second voltage range, and the third voltage range are different from one another. The third voltage range is defined as a voltage range in which the rate of change in output current density voltage in response to an increase in bias voltage is lower than the rates of change in output current density in response to increases in bias voltage in the first voltage range and the second voltage range. Alternatively, the third voltage range may be determined on the basis of the position of a rising edge (falling edge) in the graph of the I-V characteristic. The third voltage range is for example larger than -1 V and smaller than +1 V. In the third voltage range, a change in bias voltage causes almost no change in current density between the principal surfaces of the photoelectric conversion layer 15a. As illustrated in Fig. 8, in the third voltage range, the absolute value of the current density is for example less than or equal to 100 µA/cm².

### [Operation Example 1 of Imaging Device]

Next, an operation example of the imaging device 100 according to the present embodiment is described. The operation example to be described below is specifically an operation example in which the imaging device 100 acquires an image.

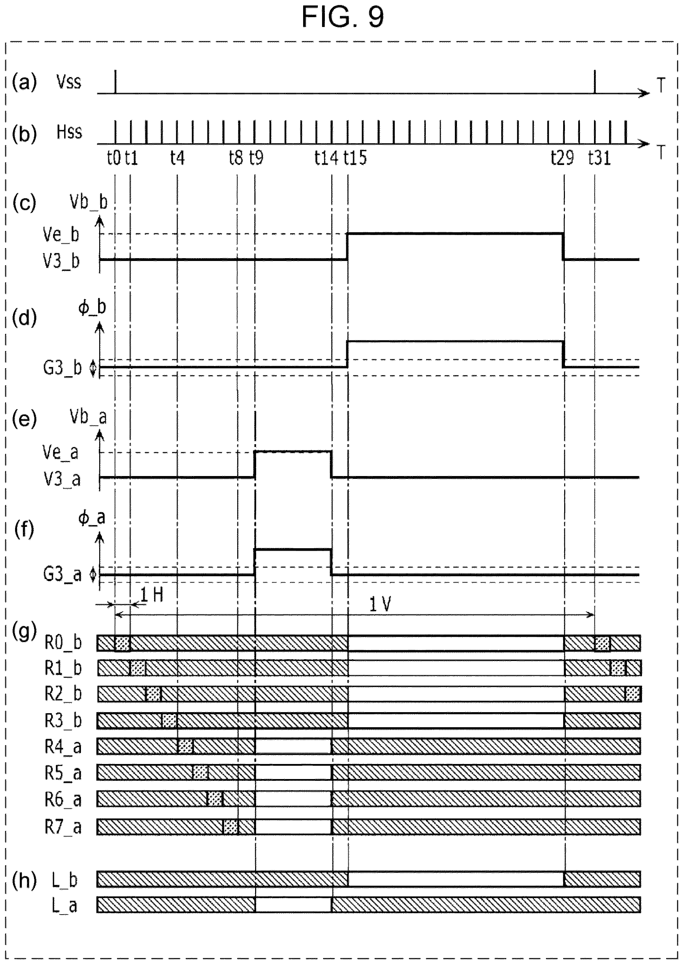

Fig. 9 is a diagram for explaining Operation Example 1 of the imaging device according to the present embodiment. Further, part of Fig. 9 shows operation of the lighting device 200 of the camera system 1. Fig. 9 shows the timing of falling edges (or rising edges) of synchronization signals, temporal changes in the magnitude of bias voltages that are applied to the photoelectric conversion layers 15a and 15b, the timing of resets and exposures in each row of the pixel array PA (see Figs. 3A and 3B), and the timing of emission of light by the lighting device 200 together.

More specifically, graph (a), at the top of Fig. 9, shows the timing of falling edges (or rising edges) of a vertical synchronization signal Vss. In the example shown in Fig. 9, the vertical synchronization signal Vss falls (or rises) at the same timing for both the pixels 10a and 10b. Graph (b) of Fig. 9 shows the timing of falling edges (or rising edges) of a horizontal synchronization signal Hss. In the example shown in Fig. 9, the horizontal synchronization signal Hss falls (or rises) at the same timing for both the pixels 10a and 10b. The vertical synchronization signal Vss and the horizontal synchronization signal Hss may vary in timing between the pixels 10a and 10b. Graph (c) of Fig. 9 shows an example of a temporal change in a voltage Vb_b that is applied from the voltage supply circuit 32b to the counter electrode 12b via the sensitivity control line 42b. Graph (d) of Fig. 9 shows a temporal change in a potential ϕ_b of the counter electrode 12b with reference to the potential of the pixel electrode 11b. The double-headed arrow G3_b in the graph of the potential ϕ_b indicates the aforementioned third voltage range in the photoelectric conversion layer 15b. Graph (e) of Fig. 9 shows an example of a temporal change in a voltage Vb_a that is applied from the voltage supply circuit 32a to the counter electrode 12a via the sensitivity control line 42a. Graph (f) of Fig. 9 shows a temporal change in a potential ϕ_a of the counter electrode 12a with reference to the potential of the pixel electrode 11a. The double-headed arrow G3_a in the graph of the potential ϕ_a indicates the aforementioned third voltage range in the photoelectric conversion layer 15a. Chart (g) of Fig. 9 schematically shows the timing of resets and exposures in each row of the pixel array PA. Chart (h) of Fig. 9 schematically shows the timing of turning on and turning off of the lighting device 200. In chart (h) of Fig. 9, the chart of L_b shows the timing of turning on and turning off of the second light source 210b, and the chart of L_a shows the timing of turning on and turning off of the first light source 210a.

The following describes Operation Example 1 of the imaging device 100 with reference to Figs. 3A, 3B, 4, and 9. For simplicity, the following describes an example of operation in which the pixel array PA includes a total of eight rows of pixels. Specifically, in chart (g) of Fig. 9, the R0_bth to R3_bth rows are four rows of pixels 10b having second photoelectric converters 13b, and the R4_ath to R7_ath rows are four rows of pixels 10a having first photoelectric converters 13a. The second photoelectric converters 13b of the R0_bth to R3_bth rows are stacked, for example, above the first photoelectric converters 13a of the R4_ath to R7_ath rows, and have such a positional relationship as to overlap the first photoelectric converters 13a of the R4_ath to R7_ath rows in a plan view. It should be noted that the order of pixel rows shown in chart (g) of Fig. 9 does not need to coincide with the actual order of pixel rows, and the actual arrangement of pixels is not limited in particular.

In the acquisition of an image, first, the resetting of the charge storage regions of each pixel 10a and each pixel 10b in the pixel array PA and the reading out of post-reset pixel signals are executed. For example, as shown in Fig. 9, the resetting of a plurality of pixels 10b belonging to the R0_bth row is started in accordance with the vertical synchronization signal Vss (time t0). It should be noted that the halftone dotted rectangles in chart (g) of Fig. 9 schematically represent signal readout periods. These readout periods may include, as part thereof, reset periods in which to reset the potentials of the charge storage regions of the pixels 10a and 10b.

In the resetting of a pixel 10b belonging to the R0_bth row, the address transistor 26b, whose gate is connected to the address control line 46b of the R0_bth row, is turned on by controlling the potential of the address control line 46b, and the reset transistor 28b, whose gate is connected to the reset control line 48b of the R0_bth row, is turned on by controlling the potential of the reset control line 48b. As a result of this, the charge storage node 41b and the reset voltage line 44b become connected to each other, and the reset voltage Vr is supplied to the charge storage region. That is, the potentials of the gate electrode 24g of the signal detection transistor 24b and the pixel electrode 11b of the second photoelectric converter 13b are reset to the reset voltage Vr. After that, a post-reset pixel signal is read out from the pixel 10b of the R0_bth row via the vertical signal line 47b. The pixel signal thus obtained is a pixel signal corresponding to the magnitude of the reset voltage Vr. After the reading out of the pixel signal, the reset transistor 28b and the address transistor 26b are turned off. In a case where a signal corresponding to the amount of signal charge stored in the pixel 10b in the preceding frame is read out, the reading out of a pixel signal may also be performed prior to a reset.

In this example, as shown in Fig. 9, the resetting and reading out of pixels belonging separately to each of the R0_bth to R3_bth and R4_ath to R7_ath rows are executed in sequence on a row-by-row basis in synchronization with the horizontal synchronization signal Hss. The period from time t0 to time t4 includes reset periods and readout periods of pixels 10b, and the period from time t4 to time t8 includes reset periods and readout periods of pixels 10a. In the following, a pulse interval of the horizontal synchronization signal Hss, i.e., a period from selection of one row to selection of the next row, is sometimes called "1H period". In this example, the period from time t0 to time t1 is equivalent to a 1H period. Further, a 1H period is equal in length to a cycle of timing of a falling edge (or a rising edge) of the horizontal synchronization signal Hss.

The resetting and reading out of a pixel 10a in the R4_ath to R7_ath rows are performed in a manner similar to the aforementioned pixel 10b. Specifically, with the R4_ath row cited as an example, the address transistor 26a, whose gate is connected to the address control line 46a of the R4_ath row, is turned on by controlling the potential of the address control line 46a, and the reset transistor 28a, whose gate is connected to the reset control line 48a of the R4_ath row, is turned on by controlling the potential of the reset control line 48a. As a result of this, the charge storage node 41a and the reset voltage line 44a become connected to each other, and the reset voltage Vr is supplied to the charge storage region. That is, the potentials of the gate electrode 24g of the signal detection transistor 24a and the pixel electrode 11a of the first photoelectric converter 13a are reset to the reset voltage Vr. After that, a post-reset pixel signal is read out from the pixel 10a of the R4_ath row via the vertical signal line 47a. After the reading out of the pixel signal, the reset transistor 28a and the address transistor 26a are turned off. In a case where a signal corresponding to the amount of signal charge stored in the pixel 10a in the preceding frame is read out, the reading out of a pixel signal may also be performed prior to a reset.

As shown in Fig. 9, during the period from the start of image acquisition to the end of the resetting of all rows of the pixel array PA and the reading out of pixel signals (from time t0 to time t8), a voltage V3_b that causes the potential difference between the pixel electrode 11b and the counter electrode 12b to fall within the aforementioned third voltage range is applied from the voltage supply circuit 32b to the counter electrode 12b. Further, during the period, a voltage V3_a that causes the potential difference between the pixel electrode 11a and the counter electrode 12a to fall within the aforementioned third voltage range is applied from the voltage supply circuit 32a to the counter electrode 12a. That is, during the period from the start of image acquisition to the start (time t9) of an exposure period of a pixel 10a belonging to the R4_ath to R7_ath rows, bias voltages in the third voltage range are applied to the photoelectric conversion layer 15a of the first photoelectric converter 13a and the photoelectric conversion layer 15b of the second photoelectric converter 13b.

In the presence of the application of bias voltages in the third voltage range to the photoelectric conversion layers 15a and 15b, the migration of signal charge from the photoelectric conversion layers 15a and 15b to the charge storage regions hardly occurs. A reason for this is that in the presence of the application of bias voltages in the third voltage range to the photoelectric conversion layers 15a and 15b, most positive and negative charges generated by illumination with light rapidly recombine to disappear before being collected by the pixel electrode 11a or 11b. Accordingly, in the presence of the application of bias voltages in the third voltage range to the photoelectric conversion layers 15a and 15b, the storage of signal charge into the signal charge regions hardly occurs even when light falls on the photoelectric conversion layers 15a and 15b. This reduces the occurrence of unintended sensitivity in a period other than the exposure period. Such unintended sensitivity is also called "parasitic sensitivity".

With attention focused on a certain row (e.g. the R0_bth row) in chart (g) of Fig. 9, the periods indicated by the halftone dotted rectangles and the shaded rectangles represent non-exposure periods. It should be noted that the voltage V3_a, which causes a bias voltage in the third voltage range to be applied to the photoelectric conversion layer 15a, and the voltage V3_b, which causes a bias voltage in the third voltage range to be applied to the photoelectric conversion layer 15b, are not limited to 0 V.

Further, since, as shown in Fig. 4, the first photoelectric converter 13a and the second photoelectric converter 13b are stacked in the imaging device 100, a capacitance coupling is formed between the first photoelectric converter 13a and the second photoelectric converter 13b. Switching of a bias voltage that is applied to the photoelectric conversion layer 15a causes a capacitance coupling that effects a change in the capacitance of a charge storage region including a charge storage node 41b connected to the second photoelectric converter 13b. Further, switching of a bias voltage that is applied to the photoelectric conversion layer 15b causes a capacitance coupling that effects a change in the capacitance of a charge storage region including a charge storage node 41a connected to the first photoelectric converter 13a. Therefore, switching of a voltage that is applied to the photoelectric conversion layer 15a or the photoelectric conversion layer 15b during a reset period and a readout period causes an output signal from the pixel 10a or the pixel 10b to fluctuate due to the change in the capacitance of the charge storage region.

In Operation Example 1, switching of a voltage that is applied to the photoelectric conversion layer 15b of the second photoelectric converter 13b is not performed during a reset period or a readout period of a pixel 10a including a first photoelectric converter 13a. As shown in Fig. 9, the voltage Vb_b, which is applied to the counter electrode 12b, is switched between the voltage V3_b and a voltage Ve_b when pixels 10a belonging separately to each of the R4_ath to R7_ath rows are in periods indicated by shaded rectangles, but the periods indicated by the shaded rectangles are neither reset periods nor readout periods of the pixels 10a. Further, switching of a voltage that is applied to the photoelectric conversion layer 15a of the first photoelectric converter 13a is not performed during a reset period or a readout period of a pixel 10b including a second photoelectric converter 13b. As shown in Fig. 9, the voltage Vb_a, which is applied to the counter electrode 12a, is switched between the voltage V3_a and a voltage Ve_a when pixels 10b belonging separately to each of the R0_bth to R3_bth rows are in periods indicated by shaded rectangles, but the periods indicated by the shaded rectangles are neither reset periods nor readout periods of the pixels 10b. That is, during reset periods and readout periods of all pixels 10a, the voltage V3_b continues to be applied to the counter electrode 12b, so that a voltage that is applied to the photoelectric conversion layer 15b of the second photoelectric converter 13b is constant. Further, during reset periods and readout periods of all pixels 10b, the voltage V3_a continues to be applied to the counter electrode 12a, so that the bias voltage that is applied to the photoelectric conversion layer 15a of the first photoelectric converter 13a is constant. As a result of this, fluctuations in the capacitance of the charge storage regions of the pixels 10a and 10b due to a capacitance coupling between the first photoelectric converter 13a and the second photoelectric converter 13b do not occur during a reset period or a readout period, so that degradation in image quality due to fluctuations of output signals can be reduced. It should be noted that "that switching of the applied voltage is not performed and the voltage is constant" herein means "that switching of the applied voltage is substantially not performed and the voltage is constant". For example, that the switching of the applied voltage is not performed and the voltage is constant during a period such as a readout period or a reset period means that the range of fluctuation in voltages that are applied separately to each of the first and second photoelectric converters 13a and 13b is less than or equal to 10% of the maximum values of bias voltages based on the supply of voltages by the voltage supply circuits connected separately to each of the first and second photoelectric converters 13a and 13b. The maximum values of the bias voltages are for example the difference between the reset voltage Vr and the voltage Ve_a and the difference between the reset voltage Vr and the voltage Ve_b.

The influence of a capacitance coupling is described in more detail here. One specific example of a capacitance coupling between the first photoelectric converter 13a and the second photoelectric converter 13b that affects the capacitance of the charge storage region of the pixel 10a in the imaging device 100 is a capacitance coupling between the pixel electrode 11a connected to the charge storage region of the pixel 10a and the counter electrode 12b. Further, another specific example of a capacitance coupling that affects the capacitance of the charge storage region of the pixel 10a is a capacitance coupling between the charge storage region of the pixel 10a and the counter electrode 12b and/or between a wire connected to the charge storage region and the counter electrode 12b.

Further, one specific example of a capacitance coupling between the first photoelectric converter 13a and the second photoelectric converter 13b that affects the capacitance of the charge storage region of the pixel 10b is a capacitance coupling between the pixel electrode 11b connected to the charge storage region of the pixel 10b and the counter electrode 12a. Further, another specific example of a capacitance coupling that affects the capacitance of the charge storage region of the pixel 10b is a capacitance coupling between the charge storage region of the pixel 10b and the counter electrode 12a and/or between a wire connected to the charge storage region and the counter electrode 12a.

As shown in Fig. 4, in the imaging device 100, the counter electrode 12a of the first photoelectric converter 13a and the pixel electrode 11b of the second photoelectric converter 13b are disposed to face each other. Therefore, of the electrodes of the first photoelectric converter 13a and the second photoelectric converter 13b, the pixel electrode 11b and the counter electrode 12a are closest to each other. As a result of that, a capacitance coupling between the pixel electrode 11b and the counter electrode 12a has a significant impact, so that a change in the capacitance of the charge storage region of the pixel 10b due to switching of a voltage that is applied to the counter electrode 12a tends to occur notably. For this reason, degradation in image quality is effectively reduced when switching of the bias voltage that is applied to the photoelectric conversion layer 15a of the first photoelectric converter 13a is not performed in a reset period or a readout period of a pixel 10b including a second photoelectric converter 13b. A capacitance coupling between the pixel electrode 11a and the counter electrode 12b too causes a change in the capacitance of the charge storage region 10a due to switching of the voltage that is applied to the counter electrode 12b. Therefore, degradation in image quality can also be reduced when switching of the bias voltage that is applied to the photoelectric conversion layer 15b of the second photoelectric converter 13b is not performed in a reset period or a readout period of a pixel 10a including a first photoelectric converter 13a.

Further, although not illustrated in Fig. 9, bias voltages that are applied to the first photoelectric converter 13a and the second photoelectric converter 13b may be changed by not only switching of voltages that are supplied from the voltage supply circuits 32a and 32b to the counter electrodes 12a and 12b but also changing of voltages that are supplied to the pixel electrodes 11a and 11b. Specifically, voltages that are supplied to charge storage regions connected to the pixel electrodes 11a and 11b are changed during reset periods and readout periods. One appropriate example is the supply of reset voltages to the charge storage regions by the reset voltage sources 34a and 34b. In such a case, changes in voltage are smaller than in a case where switching of voltages that are supplied from the voltage supply circuits 32a and 32b to the counter electrodes 12a and 12b is performed; however, a capacitance coupling between the first photoelectric converter 13a and the second photoelectric converter 13b may produce fluctuations of output signals as noted above. Therefore, as shown in Fig. 9, degradation in image quality can be reduced by preventing an overlap between a reset period and a readout period of a pixel 10a including a first photoelectric converter 13a and a reset period and a readout period of a pixel 10b including a second photoelectric converter 13b.

With continued reference to Fig. 9, after the end of the resetting of all rows of the pixel array PA and the reading out of pixel signals, exposure periods of the pixels 10a belonging to the R4_ath to R7_ath rows are started in accordance with the horizontal synchronization signal Hss (time t9). In chart (g) of Fig. 9, the white rectangles schematically represent the exposure periods separately in each of the rows. The exposure periods of the pixels 10a are started by the voltage supply circuit 32a switching the voltage that is applied to the counter electrode 12a to the voltage Ve_a, which is different from the voltage V3_a. The voltage Ve_a is a voltage (e.g. approximately 10 V) that causes the potential difference between the pixel electrode 11a and the counter electrode 12a to fall within the aforementioned first voltage range. By the voltage Ve_a being applied to the counter electrode 12a, signal charge (in the present embodiment, a hole) in the photoelectric conversion layer 15a is collected by the pixel electrode 11a and stored in a charge storage region including a charge storage node 41a.

The voltage supply circuit 32a switches the voltage that is applied to the counter electrode 12a again to the voltage V3_a, whereby the exposure periods of the pixels 10a belonging to the R4_ath to R7_ath rows end (time t14). Thus, in the present embodiment, switching of the voltage that is applied to the counter electrode 12a between the voltage V3_a and the voltage Ve_a enables switching between an exposure period and a non-exposure period. That is, an exposure period is defined by switching of a voltage that the voltage supply circuit 32a applies between the pixel electrode 11a and the counter electrode 12a. As can be seen from Fig. 9, the start (time t9) and end (time t14) of the exposure periods of the pixels 10a belonging to the R4_ath to R7_ath rows are common to all pixels 10a included in the pixel array PA.

Next, after the end of the exposure periods of the pixels 10a belonging to the R4_ath to R7_ath rows, exposure periods of the pixels 10b belonging to the R0_bth to R3_bth rows are started in accordance with the horizontal synchronization signal Hss (time t15). The exposure periods of the pixels 10b are started by the voltage supply circuit 32b switching the voltage that is applied to the counter electrode 12b to the voltage Ve_b, which is different from the voltage V3_b. The voltage Ve_b is a voltage (e.g. approximately 10 V) that causes the potential difference between the pixel electrode 11b and the counter electrode 12b to fall within the aforementioned first voltage range. By the voltage Ve_b being applied to the counter electrode 12b, signal charge (in the present embodiment, a hole) in the photoelectric conversion layer 15b is collected by the pixel electrode 11b and stored in a charge storage region including a charge storage node 41b.

The voltage supply circuit 32b switches the voltage that is applied to the counter electrode 12b again to the voltage V3_b, whereby the exposure periods of the pixels 10b belonging to the R0_bth to R3_bth rows end (time t29). Thus, in the present embodiment, switching of the voltage that is applied to the counter electrode 12b between the voltage V3_b and the voltage Ve_b enables switching between an exposure period and a non-exposure period. That is, an exposure period is defined by switching of a voltage that the voltage supply circuit 32b applies between the pixel electrode 11b and the counter electrode 12b. As can be seen from Fig. 9, the start (time t15) and end (time t29) of the exposure periods of the pixels 10b belonging to the R0_bth to R3_bth rows are common to all pixels 10b included in the pixel array PA.

Thus, the operation described here is an example in which driving in the global shutter method is applied to both pixels 10a having first photoelectric converters 13a and pixels 10b having second photoelectric converters 13b in the imaging device 100.

Further, as shown in chart (h) of Fig. 9, the lighting device 200 causes the first light source 210a to emit light during the period from the start (time t9) of an exposure period of a pixel 10a to the end (time t14). That is, the first light source 210a of the lighting device 200 emits light in a period overlapping an exposure period of a pixel 10a including a first photoelectric converter 13a. In this example, a light-emitting period of the first light source 210a and an exposure period of the pixel 10a are the same period. This causes light reflected by the subject reflecting light emitted by the first light source 210a to fall on the first photoelectric converter 13a and the second photoelectric converter 13b during the exposure period of the pixel 10a. Further, the first light source 210a is turned off during a non-exposure period of the pixel 10a. It should be noted that the white rectangles in chart (h) of Fig. 9 schematically represent light-emitting periods of the light sources. Further, the shaded rectangles in chart (h) of Fig. 9 schematically represent turned-off periods of the light sources.

Further, the lighting device 200 causes the second light source 210b to emit light during the period from the start (time t15) of an exposure period of a pixel 10b to the end (time t29). That is, the second light source 210b of the lighting device 200 emits light in a period overlapping an exposure period of a pixel 10b including a second photoelectric converter 13b. In this example, a light-emitting period of the second light source 210b and an exposure period of the pixel 10b are the same period. This causes light reflected by the subject reflecting light emitted by the second light source 210b to fall on the first photoelectric converter 13a and the second photoelectric converter 13b during the exposure period of the pixel 10b. Further, the second light source 210b is turned off during a non-exposure period of the pixel 10b.

In the camera system 1, the timing of emission of light by the lighting device 200 is controlled, for example, by the controller 300. The controller 300 for example acquires a signal representing a driving timing of a pixel in the imaging device 100 from the imaging device 100 and controls the emission of light by the lighting device 200 in accordance with the signal thus acquired. Further, the controller 300 may output, to the imaging device 100 and the lighting device 200, a signal that controls the timing of an exposure period in the imaging device 100 and the timing of a light-emitting period in the lighting device 200.

Thus, the lighting device 200 emits light by causing the first light source 210a and the second light source 210b to be lit in conjunction with the respective exposure periods of the pixels 10a and 10b. This causes the subject to be illuminated in an exposure period with illuminating light in a wavelength range to which the first photoelectric converter 13a or the second photoelectric converter 13b has sensitivity, making it possible to improve the image quality of an image that is taken by the imaging device 100. Further, the lighting device 200 does not emit light in the respective non-exposure periods of the pixels 10a and 10b. This makes it possible to achieve increased longevity and energy reduction of the first light source 210a and the second light source 210b.

Further, in the example shown in Fig. 9, the exposure period of the pixel 10a does not overlap the exposure period of the pixel 10b. Therefore, the first light source 210a, which emits light in the same period as the exposure period of the pixel 10a, does not emit light in the exposure period of the pixel 10b. For this reason, light from the first light source 210a does not affect the photoelectric conversion of the second photoelectric converter 13b. For example, in a case where the first wavelength range is a range of wavelengths in the near-infrared wavelength range and the second wavelength range is a range of wavelengths in the visible light wavelength region, the first light source 210a emits near-infrared radiation, but a near-infrared light source may emit light containing a component of visible light as part thereof. Even in such a case, a component of light that affects the photoelectric conversion of the second photoelectric converter 13b falls on the second photoelectric converter 13b, and unintended storage of signal charge in the pixel 10b can be inhibited, as the first light source 210a does not emit light in the exposure period of the pixel 10b. Further, similarly, the second light source 210b, which emits light in the same period as the exposure period of the pixel 10b, does not emit light in the exposure period of the pixel 10a. This makes it possible to inhibit unintended storage of signal charge in the pixel 10a.

It should be noted that the lighting device 200, which emits light in an exposure period, is not limited to a lighting device provided in the camera system 1 but may be an external lighting device. Further, it is not essential for the lighting device 200 to emit light, and the imaging device 100 may take an image with the lighting device 200 emitting no light.

Next, the reading out of signal charge from pixels belonging separately to each row of the pixel array PA is performed in accordance with the horizontal synchronization signal Hss. In this example, the reading out of signal charge from pixels belonging separately to each of the R0_bth to R3_bth and R4_ath to R7_ath rows are executed in sequence on a row-by-row basis from time t31. In the following, the period from selection of a pixel belonging to one row to reselection of a pixel belonging to the row is sometimes called "1V period". In this example, a period from time t0 to time t31 is equivalent to a 1V period. A 1V period is equivalent, for example, to a one-frame period. Further, a 1V period is equal in length to a cycle of timing of a falling edge (or a rising edge) of the vertical synchronization signal Vss.

In the reading out of signal charge from a pixel 10b belonging to the R0_bth row after the end of an exposure period, the address transistor 26b of the R0_bth row is turned on. This causes a pixel signal corresponding to the amount of signal charge stored in the charge storage region of the pixel 10b in the exposure period to be outputted to the vertical signal line 47b. The reading out of the pixel signal may be followed by turning on the reset transistor 28b to perform the resetting of the pixel 10b and, if necessary, the reading out of a post-reset pixel signal. After the reading out of the pixel signal or after the resetting of the pixel 10b, the address transistor 26b and, if necessary, the reset transistor 28b are turned off. The same operation is sequentially executed on a row-by-row basis on pixels 10b belonging separately to each of the R1_bth to R3_bth rows and pixels 10a belonging separately to each of the R4_ath to R7_ath rows.

Readout after the end of an exposure period of a pixel 10a in the R4_ath to R7_ath rows is performed in a manner similar to a pixel 10b. Specifically, with the R4_ath row cited as an example, first, the address transistor 26a of the R4_ath row is turned on. This causes a pixel signal corresponding to the amount of signal charge stored in the charge storage region of the pixel 10a in the exposure period to be outputted to the vertical signal line 47a. The reading out of the pixel signal may be followed by turning on the reset transistor 28a to perform the resetting of the pixel 10a and, if necessary, the reading out of a post-reset pixel signal. After the reading out of the pixel signal or after the resetting of the pixel 10a, the address transistor 26a and, if necessary, the reset transistor 28a are turned off. The same operation is sequentially executed on a row-by-row basis on pixels 10a belonging separately to each of the R5_ath to R7_ath rows.

After the reading out of signal charge from pixels belonging separately to each row of the pixel array PA after the exposure periods has been performed since time t31, signals from which stationary noise has been removed are obtained by taking the differences between signals read out after the exposure periods and signals read out during the period between time t0 and time t8. In a case where resets are performed after the reading out of pixel signals since t31 after the exposure periods, signals from which stationary noise has been removed may be obtained by taking the differences between readouts of pixel signals after the resets and readouts of pixel signals before the resets. In this case, it is not necessary to read out pixel signals after the resets during the period between time t0 and time t8.

In a non-exposure period of a pixel 10a, during which the voltage V3_a is applied to the counter electrode 12a, a bias voltage in the third voltage range is applied to the photoelectric conversion layer 15a of the first photoelectric converter 13a. Further, in a non-exposure period of a pixel 10b, during which the voltage V3_b is applied to the counter electrode 12b, a bias voltage in the third voltage range is applied to the photoelectric conversion layer 15b of the second photoelectric converter 13b. Therefore, the storage of signal charge into the signal charge regions hardly occurs even when light falls on the photoelectric conversion layer 15a and the photoelectric conversion layer 15b. This inhibits the generation of noise attributed to unintended contamination with electric charge.

From the point of view of inhibiting further storage of signal charge into a charge storage region, it is conceivable that an exposure period may be ended by applying, to the counter electrode 12a, a voltage obtained by reversing the polarity of the aforementioned voltage Ve_a. However, simply reversing the polarity of the voltage that is applied to the counter electrode 12a may cause already-stored signal charge to migrate to the counter electrode 12a via the photoelectric conversion layer 15a. The migration of signal charge from the charge storage region to the counter electrode 12a via the photoelectric conversion layer 15a is observed, for example, as a black spot in the image acquired. That is, the migration of signal charge from the charge storage region to the counter electrode 12a via the photoelectric conversion layer 15a can be a factor for negative parasitic sensitivity. The same applies to a case where a voltage obtained by reversing the polarity of the aforementioned voltage Ve_b is applied to the counter electrode 12b.

In the example, since the voltages that are applied to the counter electrodes 12a and 12b are changed again to the voltages V3_a and V3_b, respectively, after the end of exposure periods, bias voltages in the third voltage range are applied to the photoelectric conversion layers 15a and 15b after the storage of signal charge into the charge storage regions. In the presence of the application of bias voltages in the third voltage range, it is possible to inhibit signal charge already stored in a charge storage region from migrating to the counter electrode 12a via the photoelectric conversion layer 15a. Similarly, it is possible to inhibit signal charge already stored in a charge storage region from migrating to the counter electrode 12b via the photoelectric conversion layer 15b. In other words, the application of bias voltages in the third voltage range to the photoelectric conversion layers 15a and 15b makes it possible to retain, in the charge storage regions, signal charge stored during the exposure periods. This makes it possible to reduce the occurrence of negative parasitic sensitivity due to a loss of signal charge from the charge storage regions.

Thus, in the present embodiment, the starts and ends of exposure periods are controlled by the voltage Vb_a, which is applied to the counter electrode 12a, and the voltage Vb_b, which is applied to the counter electrode 12b. That is, the present embodiment makes it possible to achieve a global shutter function without providing a transfer transistor or other components in each pixel 10a or each pixel 10b. The present embodiment, in which an electronic shutter is executed by controlling the voltages Vb_a and Vb_b without transferring signal charge via a transfer transistor, makes faster operation possible. Further, not needing to separately provide a transfer transistor or other components in each pixel 10a or each pixel 10b is advantageous to finer pixels.

As noted above, in Operation Example 1, switching of the voltage that the voltage supply circuit 32a applies between the pixel electrode 11a and the counter electrode 12a is performed in a period excluding a readout period and a reset period of a pixel 10b having a second photoelectric converter 13b. As a result of this, a fluctuation in the capacitance of a charge storage region in which signal charge generated by the second photoelectric converter 13b is stored is not caused in a readout period or a reset period of the pixel 10b by capacitance couplings between the first photoelectric converter 13a and the second photoelectric converter 13b, between the first photoelectric converter 13a and the signal detection circuit 14b, and between the first photoelectric converter 13a and the charge storage region of the pixel 10b due to switching of the voltage that is applied between the pixel electrode 11a and the counter electrode 12a. This makes it possible to, even in a case where the imaging device 100 includes two photoelectric converters stacked, reduce degradation in image quality of the imaging device 100.

Further, in Operation Example 1, an exposure period of a pixel 10a is shorter than an exposure period of a pixel 10b. In a case where the first photoelectric converter 13a of the pixel 10a has sensitivity to the near-infrared wavelength region, the first photoelectric converter 13a tends to produce a dark current due to thermal excitation, as the first photoelectric converter 13a is made of a photoelectric conversion material having a narrow bandgap. Therefore, when an exposure period of a pixel 10a is shorter than an exposure period of a pixel 10b, it is possible to reduce the influence of a dark current and reduce degradation in image quality. Further, in a case where an image is taken with light emitted by the lighting device 200 in an exposure period of a pixel 10a, a period of emission of light by the lighting device 200 can be shortened. This makes it possible to lower power consumption and increase the longevity of the light sources.

Although, in Operation Example 1, an exposure period of a pixel 10a and an exposure period of a pixel 10b do not overlap, this is not intended to impose any limitation. An exposure period of a pixel 10a and an exposure period of a pixel 10b may overlap. Further, an exposure period of a pixel 10a and an exposure period of a pixel 10b may be an identical period.

Further, although, in Operation Example 1, the reading out and resetting of pixels belonging separately to each of the R0_bth to R3_bth and R4_ath to R7_ath rows are executed in sequence on a row-by-row basis, this is not intended to impose any limitation. The reading out and resetting of the pixels 10b of the R0_bth to R3_bth rows and the reading out and resetting of the pixels 10a of the R4_ath to R7_ath rows may be performed in an overlapping period, provided readout circuits are independently configured.

Further, in Operation Example 1, at least one of the first light source 210a and the second light source 210b does not need to emit light. For example, in a case where the first photoelectric converter 13a has sensitivity to the near-infrared wavelength region and the second photoelectric converter 13b has sensitivity to the visible light wavelength region, it is easy to take an image with the second photoelectric converter 13b by means of ambient light. Therefore, only the first light source 210a is utilized, and the second light source 210b does not need to emit light.

Further, the aforementioned Operation Example 1 relates to effective pixels for outputting an image, and switching of voltages that are applied to the counter electrode 12a and the counter electrode 12b may be performed in a readout period and a reset period of an ineffective pixel.

Further, even in a case where the imaging device 110 is used instead of the imaging device 100, the imaging device 110 operates so that switching of the voltage that is applied between the pixel electrode 11a and the counter electrode 12a is performed in a period excluding a readout period and a reset period of a pixel including a photoelectric converter other than a first photoelectric converter 13a.

### [Operation Example 2 of Imaging Device]

Next, another operation example of the imaging device 100 according to the present embodiment is described. The following description is given with a focus on points of difference from Operation Example 1, and a description of common features is omitted or simplified.

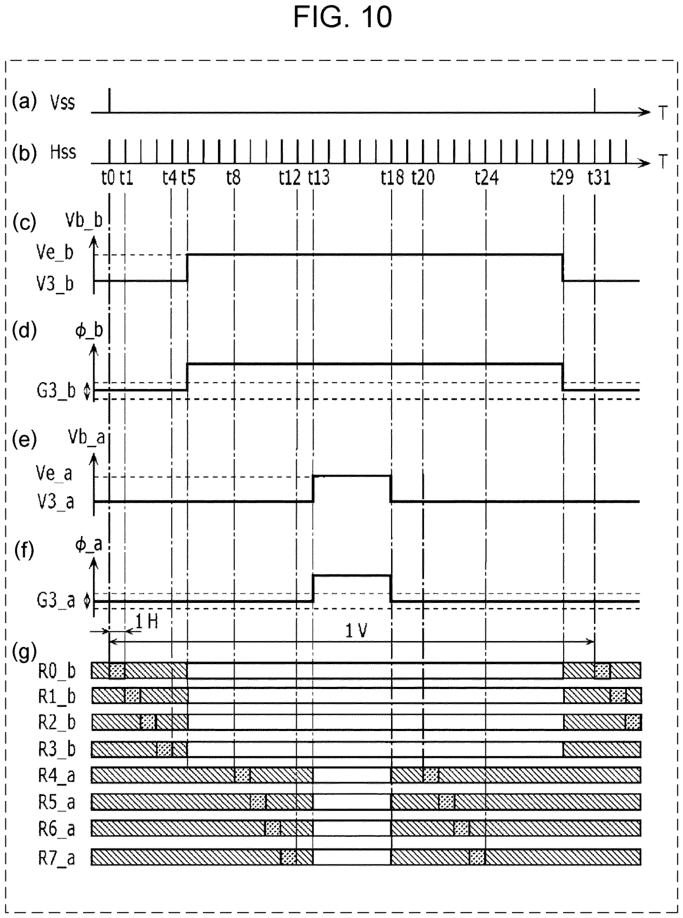

Fig. 10 is a diagram for explaining Operation Example 2 of the imaging device according to the embodiment. Portions (a) to (g) of Fig. 10 show the same items as those of portions (a) to (g) of Fig. 9.

In Operation Example 2, first, the resetting of the charge storage region of each pixel 10b in the pixel array PA and the reading out of a post-reset pixel signal are executed. For example, as shown in Fig. 10, the resetting of a plurality of pixels 10b belonging to the R0_bth row is started in accordance with the vertical synchronization signal Vss (time t0). Then, the resetting and reading out of pixels 10b belonging separately to each of the R0_bth to R3_bth rows are executed in sequence on a row-by-row basis in synchronization with the horizontal synchronization signal Hss.

As shown in Fig. 10, in reset periods and read periods of pixels 10b (from time t0 to time t4), the voltage V3_a, which causes the potential difference between the pixel electrode 11a and the counter electrode 12a to fall within the aforementioned third voltage range, is applied from the voltage supply circuit 32a to the counter electrode 12a. Therefore, switching of a voltage that the voltage supply circuit 32a applies to the photoelectric conversion layer 15a of the first photoelectric converter 13a is not performed in a reset period or a readout period of a pixel 10b including a second photoelectric converter 13b. As a result of this, a fluctuation in the capacitance of a charge storage region by capacitance couplings between the first photoelectric converter 13a and the second photoelectric converter 13b, between the first photoelectric converter 13a and the signal detection circuit 14b, and between the first photoelectric converter 13a and the charge storage region of the pixel 10b is not caused in the readout period or the reset period of the pixel 10b, so that degradation in image quality can be reduced.

After the end of the resetting of all rows of pixels 10b and the reading out of pixel signals, the voltage supply circuit 32b switches the voltage that is applied to the counter electrode 12b to the voltage Ve_b, which is different from the voltage V3_b, in accordance with the horizontal synchronization signal Hss, whereby exposure periods of the pixels 10b belonging to the R0_bth to R3_bth rows are started (time t5).

Next, during the exposure periods of the pixels 10b, the resetting of the charge storage regions of the pixels 10a in the pixel array PA and the reading out of post-reset pixel signals are executed. For example, as shown in Fig. 10, the resetting of a plurality of pixels 10a belonging to the R4_ath row is started in accordance with the horizontal synchronization signal Hss (time t8). Then, in accordance with the horizontal synchronization signal Hss, the resetting and reading out of pixels 10a belonging separately to each of the R4_ath to R7_ath rows are executed in sequence on a row-by-row basis.

As shown in Fig. 10, in reset periods and readout periods of pixels 10a (from time t8 to time t12), the voltage Ve_b, which causes the potential difference between the pixel electrode 11b and the counter electrode 12b to fall within the aforementioned first voltage range, is applied from the voltage supply circuit 32b to the counter electrode 12b. Therefore, switching of a voltage that the voltage supply circuit 32b applies to the photoelectric conversion layer 15b of the second photoelectric converter 13b is not performed in a reset period or a readout period of a pixel 10a including a first photoelectric converter 13a. As a result of this, a fluctuation in the capacitance of a charge storage region by capacitance couplings between the first photoelectric converter 13a and the second photoelectric converter 13b, between the signal detection circuit 14a and the second photoelectric converter 13b, and between the charge storage region of the pixel 10a and the second photoelectric converter 13b is not caused in the readout period or the reset period of the pixel 10a, so that degradation in image quality can be reduced.

After the end of the resetting of all rows of pixels 10a and the reading out of pixel signals, the voltage supply circuit 32a switches the voltage that is applied to the counter electrode 12a to the voltage Ve_a, which is different from the voltage V3_a, in accordance with the horizontal synchronization signal Hss, whereby exposure periods of the pixels 10a belonging to the R4_ath to R7_ath rows are started (time t13). Then, the voltage supply circuit 32a switches the voltage that is applied to the counter electrode 12a again to the voltage V3_a, whereby the exposure periods of the pixels 10a belonging to the R4_ath to R7_ath rows end (time t18).

In Operation Example 2, the reading out of signal charge of each pixel 10a in the pixel array PA is further performed in the exposure periods of the pixels 10b. In this example, the reading out of signal charge from pixels 10a belonging separately to each of the R4_ath to R7_ath rows is executed in sequence on a row-by-row basis during the period from time t20 to time t24. This causes pixel signals corresponding to the amounts of signal charge stored in the charge storage regions of the pixels 10a in the exposure periods of the pixels 10b to be outputted to the vertical signal lines 47a. As in Operation Example 1, the reading out of the pixel signals may be followed by performing the resetting of the pixel 10a and, if necessary, the reading out of post-reset pixel signals. After the reading out of signal charge of the pixels 10a after the exposure periods has been performed since time t20, signals from which stationary noise has been removed are obtained by taking the differences between signals read out after the exposure periods and signals read out during the period between time t8 and time t12.

As shown in Fig. 10, in the reading periods (and reset periods) of the pixels 10a during the period from time t20 to time t24 too, the voltage Ve_b is applied from the voltage supply circuit 32b to the counter electrode 12b. Therefore, switching of a voltage that the voltage supply circuit 32b applies to the photoelectric conversion layer 15b of the second photoelectric converter 13b is not performed in a reset period or a readout period of a pixel 10a including a first photoelectric converter 13a.

Next, the voltage supply circuit 32b switches the voltage that is applied to the counter electrode 12b again to the voltage V3_b, whereby the exposure periods of the pixels 10b belonging to the R0_bth to R3_bth rows end (time t29).

Next, the reading out and resetting of signal charge of all rows of pixels 10b are performed in accordance with the horizontal synchronization signal Hss. In this example, the reading out of signal charge from pixels 10b belonging separately to each of the R0_bth to R3_bth rows is executed in sequence on a row-by-row basis from time t31. This causes pixel signals corresponding to the amounts of signal charge stored in the charge storage regions of the pixels 10b in the exposure periods to be outputted to the vertical signal lines 47b. The reading out of the pixel signals may be followed by performing the resetting of the pixel 10b and, if necessary, the reading out of post-reset pixel signals. After the reading out of signal charge of the pixels 10b after the exposure periods has been performed since time t31, signals from which stationary noise has been removed are obtained by taking the differences between signals read out after the exposure periods and signals read out during the period between time t0 and time t4.

As noted above, in Operation Example 2 too, as in Operation Example 1, switching of the voltage that is applied between the pixel electrode 11a and the counter electrode 12a is performed in a period excluding a readout period and a reset period of a pixel 10b having a second photoelectric converter 13b. This makes it possible to, even in a case where the imaging device 100 includes two photoelectric converters stacked, reduce degradation in image quality of the imaging device 100.

Further, in Operation Example 2, an exposure period of a pixel 10a is shorter than an exposure period of a pixel 10b, and the exposure period and a readout period of the pixel 10a are included within the exposure period of the pixel 10b. This makes it possible to lengthen the exposure period of the pixel 10b without lengthening a one-frame period, making it possible to increase sensitivity during imaging with the pixel 10b. For example, even when the light sources are not used but ambient light is used, an image can be taken with sufficient sensitivity by the second photoelectric converter 13b. For example, in a case where the second photoelectric converter 13b has sensitivity to the visible light wavelength region, the sensitivity of imaging with visible light can be increased, so that image quality can be improved.

Furthermore, in Operation Example 2, an exposure period and a readout period of a pixel 10b are included in this order within an exposure period of a pixel 10b having a second photoelectric converter 13b. As a result of this, the exposure to readout of the pixel 10a are performed during the exposure period of the pixel 10b, so that the period from exposure to readout of the pixel 10a can be shortened. Therefore, unintended storage of electric charge by parasitic sensitivity is inhibited. This makes it possible to improve the image quality of an image that is taken with the first photoelectric converter 13a.

Further, in Operation Example 2, a reset period preceding an exposure period of a pixel 10b too is included within an exposure period of a pixel 10b. That is, a reset period, an exposure period, and a readout period of a pixel 10a are included in this order within an exposure period of a pixel 10b having a second photoelectric converter 13b. As a result of this, the reset to readout of the pixel 10a are performed during the exposure period of the pixel 10b, so that the period from reset before the exposure period of the pixel 10a to readout after the exposure period can be shortened. Therefore, unintended storage of electric charge by parasitic sensitivity is inhibited. This makes it possible to improve the image quality of an image that is taken with the first photoelectric converter 13a. Further, the exposure period of the pixel 10a too is shortened, which brings about effects that are similar to those of the aforementioned Operation Example 1.

In Operation Example 2 too, as in Operation Example 1, the lighting device 200 may cause the first light source 210a to emit light during a period overlapping an exposure period of a pixel 10a. Further, the lighting device 200 may cause the second light source 210b to emit light during a period overlapping an exposure period of a pixel 10b.

Further, in Operation Example 2 the timing of the start and end of an exposure period of a pixel 10b is not limited to the foregoing example. For example, an exposure period of a pixel 10b may start after time t12 and does not need to overlap a reading period or a reset period of a pixel 10a during the period from time t8 to time t12. Further, for example, an exposure period of a pixel 10b may start before time t20 and does not need to overlap a reading period (or a reset period) of a pixel 10a during the period from time t20 to time t24.

### [Comparative Example]

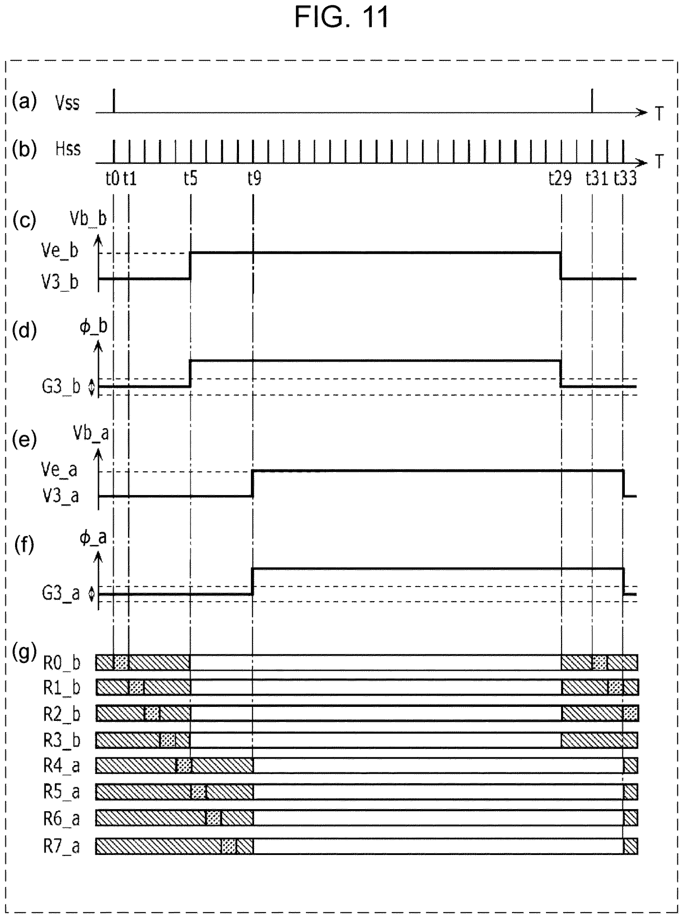

Next, a comparative example of operation of the imaging device 100 is described. Fig. 11 is a diagram for explaining the comparative example of operation of the imaging device. Portions (a) to (g) of Fig. 11 show the same items as those of portions (a) to (g) of Fig. 9.

First, the resetting of the charge storage regions of each pixel 10a and each pixel 10b in the pixel array PA and the reading out of post-reset pixel signals are executed. For example, as shown in Fig. 11, the resetting of a plurality of pixels 10b belonging to the R0_bth row is started in accordance with the vertical synchronization signal Vss (time t0). Then, the resetting and reading out of pixels belonging separately to each of the R0_bth to R3_bth and R4_ath to R7_ath rows are executed in sequence on a row-by-row basis in synchronization with the horizontal synchronization signal Hss.

Next, while the resetting of the charge storage regions of each pixel 10a and each pixel 10b in the pixel array PA and the reading out of post-reset pixel signals are being executed, the voltage supply circuit 32b switches the voltage that is applied to the counter electrode 12b to the voltage Ve_b, which is different from the voltage V3_b, whereby exposure periods of the pixels 10b belonging to the R0_bth to R3_bth rows are started (time t5). Therefore, in this example, a voltage that is applied to the photoelectric conversion layer 15b is switched during a period in which the resetting and reading out of the pixels 10a belonging to the R4_ath to R5_ath rows are performed. Specifically, the voltage V3_b is applied to the counter electrode 12b during the resetting and reading out of the pixels 10a belonging to the R4_ath row. Meanwhile, the voltage Ve_b is applied to the counter electrode 12b during the resetting and reading out of the pixels 10a belonging to the R5_ath row. Therefore, a capacitance coupling between the first photoelectric converter 13a and the second photoelectric converter 13b or other capacitance couplings effect changes in the capacitance of the charge storage regions of the pixels 10a, and output signals fluctuate between the pixels 10a belonging to the R4_ath row and the pixels 10a belonging to the R5_ath row regardless of the amounts of signal charge stored in the charge storage regions. For example, a difference in level of output is made between the pixels 10a belonging to the R4_ath row and the pixels 10a belonging to the R5_ath row, and image quality degrades.

Next, after the end of the resetting of all rows of the pixel array PA and the reading out of pixel signals, the voltage supply circuit 32a switches the voltage that is applied to the counter electrode 12a to the voltage Ve_a, which is different from the voltage V3_a, in accordance with the horizontal synchronization signal Hss, whereby exposure periods of the pixels 10a belonging to the R4_ath to R7_ath rows are started (time t9).

Next, the voltage supply circuit 32b switches the voltage that is applied to the counter electrode 12b again to the voltage V3_b, whereby the exposure periods of the pixels 10b belonging to the R0_bth to R3_bth rows end (time t29). After the end of the exposure periods of the pixels 10b belonging to the R0_bth to R3_bth rows, the reading out of signal charge from pixels belonging separately to each row of the pixel array PA is performed. In this example, the reading out of signal charge from pixels belonging separately to each of the R0_bth to R3_bth and R4_ath to R7_ath rows are executed in sequence on a row-by-row basis from time t31.

Next, while the reading out of signal charge from pixels belonging separately to each row of the pixel array PA is being performed, the voltage supply circuit 32a switches the voltage that is applied to the counter electrode 12a again to the voltage V3_a, whereby the exposure periods of the pixels 10a belonging to the R4_ath to R7_ath rows end (time t33). Therefore, in this example, a voltage that is applied to the photoelectric conversion layer 15a is switched during a period in which the reading out of the pixels 10b belonging to the R1_bth to R2_bth rows is performed. Specifically, the voltage Ve_a is applied to the counter electrode 12a during the reading out of the pixels 10b belonging to the R1_bth row. Meanwhile, the voltage V3_a is applied to the counter electrode 12a during the reading out of the pixels 10b belonging to the R2_bth row. Therefore, a capacitance coupling between the first photoelectric converter 13a and the second photoelectric converter 13b or other capacitance couplings effect changes in the capacitance of the charge storage regions of the pixels 10b, and output signals fluctuate between the pixels 10b belonging to the R1_bth row and the pixels 10b belonging to the R2_bth row regardless of the amounts of signal charge stored in the charge storage regions. For example, a difference in level of output is made between the pixels 10b belonging to the R1_bth row and the pixels 10b belonging to the R2_bth row, and image quality degrades.

Thus, in the comparative example, switching of the voltage that is applied to the photoelectric conversion layer 15a of the first photoelectric converter 13a is performed in a reset period and a readout period of a pixel 10b including a second photoelectric converter 13b, and switching of the voltage that is applied to the photoelectric conversion layer 15b of the second photoelectric converter 13b is performed in a reset period and a readout period of a pixel 10a including a first photoelectric converter 13a. Therefore, such switching of voltages effects changes in the capacitance of the charge storage regions of the pixels 10a and 10b during the reset periods and the readout periods, resulting in degradation in image quality of the imaging device 100.

On the other hand, in the aforementioned Operation Examples 1 and 2 of the imaging device 100, switching of the voltage that is applied to the photoelectric conversion layer 15a of the first photoelectric converter 13a is not performed in a reset period or a readout period of a pixel 10b including a second photoelectric converter 13b, and switching of the voltage that is applied to the photoelectric conversion layer 15b of the second photoelectric converter 13b is not performed in a reset period or a readout period of a pixel 10a including a first photoelectric converter 13a. Therefore, unlike in the comparative example, there is no degradation of image quality due to changes in the capacitance of the charge storage regions, and degradation in image quality of the imaging device 100 can be reduced.

### (Other Embodiments)

While the foregoing has described an imaging device and a camera system according to the present disclosure with reference to embodiments, the present disclosure is not intended to be limited to these embodiments. Various modifications conceived of by persons skilled in the art are encompassed in the scope of the present disclosure. Further, constituent elements of different embodiments may be arbitrarily combined without departing from the scope of the present disclosure.

For example, although, in the foregoing embodiment, switching of the voltage that the voltage supply circuit 32a applies and switching of the voltage that the voltage supply circuit 32b applies are performed to define exposure periods, this is not intended to impose any limitation. Switching of the voltage that the voltage supply circuit 32a applies and switching of the voltage that the voltage supply circuit 32b applies may be performed to change sensitivity during exposure periods.

Further, for example, although, in the foregoing embodiment, the voltage supply circuit 32a switches the applied voltage between two values, namely the voltage V3_a and the voltage Ve_b, the voltage supply circuit 32a may switch the applied voltage among three or more values. Similarly, the voltage supply circuit 32b may switch the applied voltage among three or more values.

Further, for example, although, in the foregoing embodiment, the imaging device 100 drives both the pixels 10a and 10b by the global shutter method, this is not intended to impose any limitation. The imaging device 100 may switch the driving of at least either the pixels 10a or 10b from the global shutter method to the rolling shutter method depending on the subject. In the rolling shutter driving of the pixels 10a, the voltage that the voltage supply circuit 32a applies to the counter electrode 12a may be fixed at the voltage Ve_a both in an exposure period and a non-exposure period. In this case, an exposure period can be defined by the time from the timing of a reset of a charge storage region including a charge storage node 41a to a signal readout. Similarly, in the rolling shutter driving of the pixels 10b, the voltage that the voltage supply circuit 32b applies to the counter electrode 12b may be fixed at the voltage Ve_b both in an exposure period and a non-exposure period. In this case, an exposure period can be defined by the time from the timing of a reset of a charge storage region including a charge storage node 41b to a signal readout.

Further, for example, in the foregoing embodiment, the circuits connected to the pixels 10a and the circuits connected to the pixel 10b may be partially shared. For example, at least any of the voltage supply circuits 32a and 32b, the reset voltage sources 34a and 34b, the vertical scanning circuits 36a and 36b, the horizontal signal readout circuits 38a and 38b, and the power wires 40a and 40b may be a single shared circuit connected to both the pixels 10a and 10b.

Further, for example, in the foregoing embodiment, the signal detection circuit 14a and the signal detection circuit 14b may share some circuit element. For example, by having switches or other pieces of equipment capable of switching between connections to the charge storage node 41a and the charge storage node 41b, the signal detection circuit 14a and the signal detection circuit 14b may share a circuit element including a signal detection transistor or an address transistor.

Further, although, in the foregoing embodiment, the signal detection transistors 24a and 24b, the address transistors 26a and 26b, and the reset transistors 28a and 28b are N-channel MOSFETs, this is not intended to impose any limitation. At least one of the signal detection transistors 24a and 24b, the address transistors 26a and 26b, and the reset transistors 28a and 28b may be a P-channel MOSFET. Further, at least one of the signal detection transistors 24a and 24b, the address transistors 26a and 26b, and the reset transistors 28a and 28b may be not a field-effect transistor but another transistor such as a bipolar transistor.

Further, although, in the foregoing embodiment, the first photoelectric converter 13a and the second photoelectric converter 13b are each configured to have a photoelectric conversion layer sandwiched between a pair of electrodes and a pair of electrodes, this is not intended to impose any limitation. For example, one of the first photoelectric converter 13a and the second photoelectric converter 13b may be configured to have a photodiode provided over the semiconductor substrate 20.

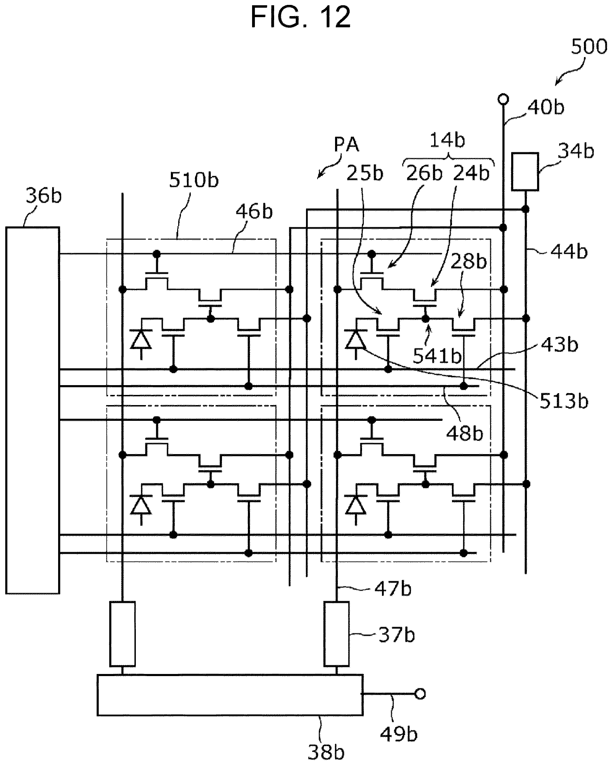

Fig. 12 is a schematic view showing an exemplary circuit configuration of pixels each including a second photoelectric converter and peripheral circuits in an imaging device according to a modification. A description of the imaging device 500 according to the modification is given with a focus on points of difference from the imaging device 100 according to the embodiment, and a description of common features are omitted or simplified.

The imaging device 500 according to the modification differs from the imaging device 100 according to the embodiment in that the imaging device 500 includes pixels 510b instead of the pixels 10b and does not include the voltage supply circuit 32b. The pixels 510b are each configured to have a second photoelectric converter 513b and a charge storage node 541b instead of the second photoelectric converter 13b and the charge storage node 41b of a pixel 10b and further have a transfer transistor 25b. In the present modification, each of the pixels 510b is an example of the second pixel.

The imaging device 500 according to the modification is provided in the camera system 1, for example, instead of the imaging device 100.

As shown in Fig. 12, the imaging device 500 includes a pixel array PA including a plurality of the pixels 510b arrayed two-dimensionally. The circuit configuration of a plurality of pixels 10a of the imaging device 500 is for example the same as that of the imaging device 100, and the configuration shown in Fig. 3A is applicable.

Each pixel 510b has a second photoelectric converter 513b, a signal detection circuit 14b, a transfer transistor 25b, and a reset transistor 28b. As will be described later with reference to the drawings, the second photoelectric converter 513b has a photodiode provided over the semiconductor substrate 20 and generates signal charge upon receiving incident light. The second photoelectric converter 513b has sensitivity, for example, to a range of wavelengths in the visible light wavelength region.

In the pixel 510b, the signal detection circuit 14b detects signal charge generated by the second photoelectric converter 513b.

The transfer transistor 25b may be a field-effect transistor. Unless otherwise noted, the following describes an example in which an N-channel MOSFET is applied as the reset transistor 25b. It should be noted that the transfer transistor 25b may be a P-channel MOSFET. Further, the transfer transistor 25b may be not a field-effect transistor but another transistor such as a bipolar transistor.

As schematically shown in Fig. 12, the input terminal of the transfer transistor 25b has an electrical connection to the second photoelectric converter 513b. Specifically, the input terminal of the transfer transistor 25b is connected to a cathode electrode of the photodiode of the second photoelectric converter 513b. The output terminal of the transfer transistor 25b is connected to the charge storage node 541b. That is, the second photoelectric converter 513b is connected to the charge storage node 541b via the transfer transistor 25b. The control terminal of the transfer transistor 25b is connected to a transfer control line 43b. By controlling the potential of the transfer control line 43b, signal charge generated by the second photoelectric converter 513b and stored in the second photoelectric converter 513b is transferred to a charge storage region including the charge storage node 541b. The charge storage region including the charge storage node 541b stores the signal charge transferred from the second photoelectric converter 513b.

These transfer control lines 43b are connected to the vertical scanning circuit 36b for each separate pixel row. Accordingly, the vertical scanning circuit 36b applies a predetermined voltage to the transfer control lines 43b, whereby signal charge of the second photoelectric converters 513b of a plurality of pixels 510b arranged in each row can be transferred to the charge storage nodes 541b on a row-by-row basis.

In each of the pixels 510b, the control terminal of the signal detection transistor 24b is connected to the charge storage node 541b. The signal detection transistor 24b amplifies and outputs signal charge transferred from the second photoelectric converter 513b to the charge storage region including the charge storage node 541b.

In each of the pixels 510b, the reset transistor 28b is connected between the reset voltage line 44b and the charge storage node 541b. The control terminal of the reset transistor 28b is connected to a reset control line 48b, and by controlling the potential of the reset control line 48b, the potential of the charge storage node 541b can be reset to the reset voltage Vr. Further, in a case where the transfer transistor 25b is in an on-state, the potential of the second photoelectric converter 513b too is reset at the same time as that of the charge storage node 541b.

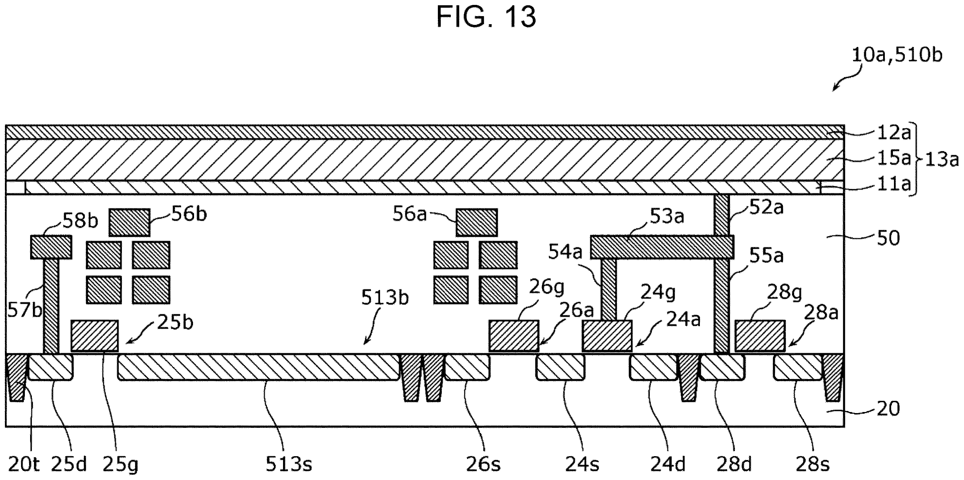

Next, a cross-section structure of pixels of the imaging device 500 according to the modification is described. Fig. 13 is a cross-sectional view schematically showing an exemplary cross-section structure of pixels 10a and 510b according to the modification.

As shown in Fig. 13, the second photoelectric converter 513b and the transfer transistor 25b are formed in the semiconductor substrate 20. It should be noted that the signal detection transistor 24b, the address transistor 26b, and the reset transistor 28b are formed in positions in the semiconductor substrate 20 that are not shown in the cross-section shown in Fig. 13.

The semiconductor substrate 20 has impurity regions 25d and 513s. The impurity regions 25d and 513s are N-type regions here. The impurity regions 25d and 513s are for example diffusion layers formed in the semiconductor substrate 20.

The second photoelectric converter 513b is for example an embedded silicon photodiode, formed in the semiconductor substrate 20, that includes the impurity region 513s. These impurity regions 513s are provided separately for each of the pixels 510b.

The transfer transistor 25b includes the impurity region 25d, part of the impurity region 513s, and a gate electrode 25g connected to the transfer control line 43b (see Fig. 12), which is not illustrated in Fig. 13. The gate electrode 25g is made of a conducting material. The conducting material is for example polysilicon rendered conductive by being doped with an impurity, but may be a metal material.

In the imaging device 500, a contact plug 57b and a wire 58b are formed in the interlayer insulating layer 50. The contact plug 57b is made, for example, of polysilicon rendered conductive by being doped with an impurity. The wire 58b is made, for example, of a metal such as copper. The impurity region 25d is connected to a first end of the contact plug 57b. A second end of the contact plug 57b is connected to the wire 58b. The contact plug 57b and the wire 58b constitute part of the charge storage node 541b (see Fig. 12). The wire 58b may be part of the wiring layer 56b. In the configuration illustrated in Fig. 13, the wire 58b, the contact plug 57b, and the impurity region 25d function as a charge storage region of the pixel 510b to which signal charge of the second photoelectric converter 513b is transferred.

In the imaging device 500, the first photoelectric converter 13a is stacked above the second photoelectric converter 513b via the interlayer insulating layer 50. The first photoelectric converter 13a overlaps, in a plan view, a charge storage region connected to the second photoelectric converter 513b. Although the first photoelectric converter 13a and the charge storage region connected to the second photoelectric converter 513b are electrically insulated from each other by the interlayer insulating layer 50, a change in a voltage that is applied, for example, to the counter electrode 12a of the first photoelectric converter 13a causes a capacitance coupling that affects the capacitance of the charge storage region connected to the second photoelectric converter 513b. In the imaging device 500, switching of the voltage that the voltage supply circuit 32a applies to the first photoelectric converter 13a is performed at an appropriate timing, so that image quality degradation due to the influence of such a capacitance coupling can be reduced. Operation of the imaging device 500 will be described in detail later.

In the imaging device 500, the pixel electrode 11a of the first photoelectric converter 13a is for example a transparent electrode. Since, in the example shown in Fig. 13, the pixel electrode 11a overlaps the second photoelectric converter 513b in a plan view, it is desirable that the pixel electrode 11a be a transparent electrode. In a case where the pixel electrode 11a does not overlap the second photoelectric converter 513b in a plan view, the pixel electrode 11a may be an opaque electrode made of a metal or other materials. On the second photoelectric converter 513b, light having passed through the first photoelectric converter 13a and the interlayer insulating layer 50 falls. The first photoelectric converter 13a and the interlayer insulating layer 50 allow passage of at least part of light of wavelengths to which the second photoelectric converter 513b has sensitivity.

Next, an operation example of the imaging device 500 according to the modification is described. The operation example to be described below is specifically an operation example in which the imaging device 500 acquires an image. A description of the operation example of the imaging device 500 is given with a focus on points of difference from the operation example of the imaging device 100, and a description of common features are omitted or simplified.

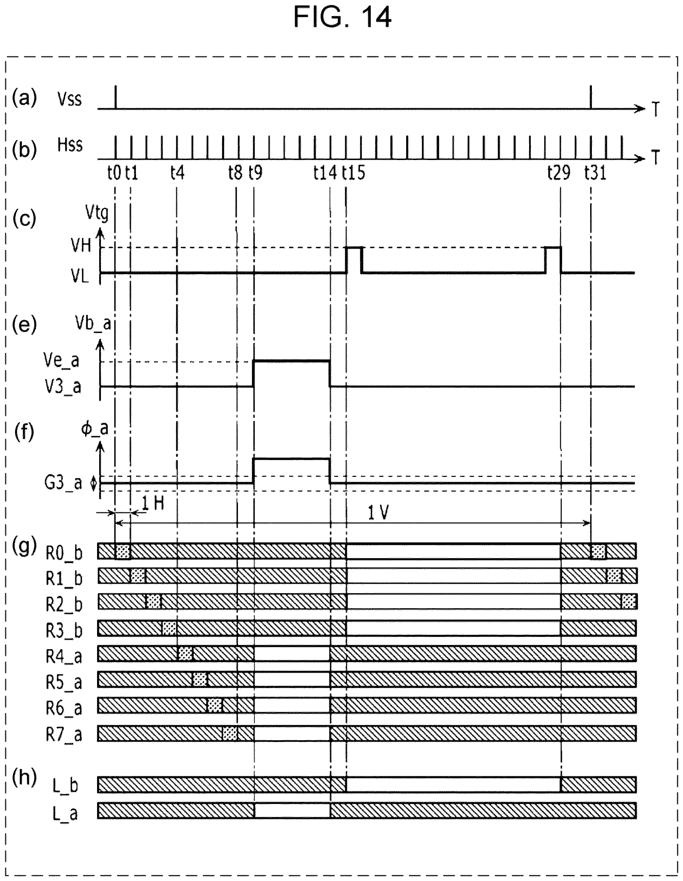

Fig. 14 is a diagram for explaining an operation example of the imaging device 500 according to the modification. Portions (a), (b), and (e) to (h) of Fig. 14 show the same items as those of portions (a), (b), and (e) to (h) of Fig. 9. The graph in portion (c) of Fig. 14 shows an example of a temporal change in a voltage Vtg that is applied to the control terminal of the transfer transistor 25b by the transfer control line 43b. The transfer transistor 25b is off in a case where the voltage Vtg, which is applied to the control terminal, is VL, and is on in a case where the voltage Vtg, which is applied to the control terminal, is VH.

In the present operation example, signal readout periods and exposure periods of the pixels 10a are identical in timing to those of the pixels 10a of Operation Example 1 of the imaging device 100. Further, in present operation example, signal readout periods and exposure periods of the pixels 510b are identical in timing to those of the pixels 10b of Operation Example 1 of the imaging device 100.

In the present operation example, operation that is similar to that of Operation Example 1 of the imaging device 100 described with reference to Fig. 9 is performed until time t14. Further, the voltage Vtg, which is applied to the control terminal of the transfer transistor 25b, is a voltage VL until time t14. Next, after the end of exposure periods of pixels 10a belonging to the R4_ath to R7_ath rows, exposure periods of pixels 510b belonging to the R0_bth to R3_bth rows are started in accordance with the horizontal synchronization signal Hss (time t15). The exposure period of each of the pixels 510b is started by the vertical scanning circuit 36b temporarily switching the voltage Vtg, which is applied to the control terminal of the transfer transistor 25b, from the voltage VL to a voltage VH. This causes the transfer transistor 25b to be temporarily turned on. Further, in the meantime, the reset transistor 28b too is on, and the charge storage region of the pixel 510b and the potential of the second photoelectric converter 513b are reset. The transfer transistor 25b is turned off again, whereby signal charge generated by the second photoelectric converter 513b receiving light is stored in the second photoelectric converter 513b without being transferred to the charge storage node 541b. Further, the reset transistor 28b too is turned off during the exposure period of the pixel 510b. Although, in the example shown in Fig. 14, the exposure period is started at a timing when the transfer transistor 25b is turned on, the exposure period may be started at a timing when the transfer transistor 25b is turned off after being turned on.

Next, the vertical scanning circuit 36b temporarily switches the voltage Vtg, which is applied to the control terminal of the transfer transistor 25b, from the voltage VL to the voltage VH, whereby the exposure period of each of the pixels 510b ends (time t29). As a result of this, the transfer transistor 25b is temporarily turned off, and signal charge stored in the second photoelectric converter 513b is transferred via the transfer transistor 25b to the charge storage region including the charge storage node 541b. From the end of exposure to the signal readout period of the pixel 5 10b, the reset transistor 28b is off, and the signal charge transferred from the second photoelectric converter 513b to the charge storage region of the pixel 510b and stored in the charge storage region is sequentially read out in the signal readout period of the pixel 510b. Although, in the example shown in Fig. 14, the exposure period is ended at a timing when the transfer transistor 25b is turned off after being turned on, the exposure period may be ended at a timing when the transfer transistor 25b is turned on.

Further, in the operation example of the imaging device 500 too, as in Operation Example 1 of the imaging device 100, when switching of the voltage that the voltage supply circuit 32a applies between the pixel electrode 11a and the counter electrode 12a is performed in order to define an exposure period of a pixel 10a, it is performed in a period excluding a readout period and a reset period of a pixel 510b. As a result of this, a fluctuation in the capacitance of a charge storage region in which signal charge generated by the second photoelectric converter 513b is stored is not caused in a readout period or a reset period of the pixel 510b by capacitance couplings between the first photoelectric converter 13a and the signal detection circuit 14b and between the first photoelectric converter 13a and the charge storage region connected to the second photoelectric converter 513b due to switching of the voltage that is applied between the pixel electrode 11a and the counter electrode 12a. Therefore, the imaging device 500 can reduce image quality degradation.

### Industrial Applicability

An imaging device according to the present disclosure is applicable, for example, to an image sensor or other sensors. Further, an imaging device according to the present disclosure can be used in a camera for medical use, a camera for use in a robot, a security camera, a camera that is mounted on a vehicle for use, or other cameras.

### Reference Signs List

1 camera system
10a, 10b, 510b pixel
11a, 11b, 11c, 11d pixel electrode
12a, 12b, 12c, 12d counter electrode
13a first photoelectric converter
13b, 513b second photoelectric converter
13c, 13d photoelectric converter
14a, 14b, 14c, 14d signal detection circuit
15a, 15b, 15c, 15d photoelectric conversion layer
20 semiconductor substrate
20t device isolation region
24a, 24b signal detection transistor
24d, 24s, 25d, 26s, 28d, 28s, 513s impurity region
24g, 25g, 26g, 28g gate electrode
25b transfer transistor
26a, 26b address transistor
28a, 28b reset transistor
32a, 32b voltage supply circuit
34a, 34b reset voltage source
36a, 36b vertical scanning circuit
37a, 37b column signal processing circuit
38a, 38b horizontal signal readout circuit
40a, 40b power wire
41a, 41b, 541b charge storage node
42a, 42b sensitivity control line
43b transfer control line
44a, 44b reset voltage line
46a, 46b address control line
47a, 47b vertical signal line
48a, 48b reset control line
49a, 49b horizontal common signal line
50 interlayer insulating layer
52a, 52b, 52c, 52d plug
53a, 53b, 58b wire
54a, 54b, 55a, 55b, 57b contact plug
56a, 56b wiring layer
61b, 61c, 61d insulating coating
62, 62a, 62b insulating layer
100, 110, 500 imaging device
150, 151 photoelectric conversion structure
150e, 151e electron blocking layer
150h, 151h hole blocking layer
150m, 151m mixed layer
150n, 151n n-type semiconductor layer
150p, 151p p-type semiconductor layer
200 lighting device
210a first light source
210b second light source
300 controller
600 subject
602 illuminating light
604 reflected light
PA pixel array

## Claims

1. An imaging device comprising:
a first pixel;
a second pixel; and
a first voltage supply circuit, wherein
the first pixel includes
a first photoelectric converter that generates signal charge by photoelectric conversion, and
a first signal detection circuit connected to the first photoelectric converter,
the second pixel includes
a second photoelectric converter, stacked above the first photoelectric converter, that generates signal charge by photoelectric conversion, and
a second signal detection circuit connected to the second photoelectric converter,
the first voltage supply circuit supplies a voltage to the first photoelectric converter,
the first photoelectric converter includes
a first pixel electrode,
a first counter electrode facing the first pixel electrode, and
a first photoelectric conversion layer located between the first pixel electrode and the first counter electrode, and
a voltage that the first voltage supply circuit applies between the first pixel electrode and the first counter electrode is switched between a plurality of voltages in part of a one-frame period excluding a readout period and a reset period of the second photoelectric converter.

2. The imaging device according to claim 1, wherein the first pixel and the second pixel are effective pixels.

3. The imaging device according to claim 1 or 2, wherein the first photoelectric converter has sensitivity that is able to be changed by the voltage that is applied between the first pixel electrode and the first counter electrode being switched between the plurality of voltages.

4. The imaging device according to claim 3, wherein the first photoelectric converter is driven by a global shutter method by which an exposure period is defined by the voltage that is applied between the first pixel electrode and the first counter electrode being switched between the plurality of voltages.

5. The imaging device according to claim 1 or 2, further comprising a second voltage supply circuit that supplies a voltage to the second photoelectric converter, wherein
the second photoelectric converter includes
a second pixel electrode,
a second counter electrode facing the second pixel electrode, and
a second photoelectric conversion layer located between the second pixel electrode and the second counter electrode,
the second photoelectric converter has sensitivity that is able to be changed by a voltage that is applied between the second pixel electrode and the second counter electrode being switched between a plurality of voltages, and
the second photoelectric converter is driven by a global shutter method by which an exposure period is defined by the voltage that is applied between the second pixel electrode and the second counter electrode being switched between the plurality of voltages.

6. The imaging device according to claim 1 or 2, wherein an exposure period and a readout period of the first photoelectric converter are included within an exposure period of the second photoelectric converter.

7. The imaging device according to claim 1 or 2, wherein an exposure period and a readout period of the first photoelectric converter are included in this order within an exposure period of the second photoelectric converter.

8. The imaging device according to claim 7, wherein a reset period, the exposure period, and the readout period of the first photoelectric converter are included in this order within the exposure period of the second photoelectric converter.

9. The imaging device according to claim 1 or 2, further comprising:
a third photoelectric converter stacked above the first photoelectric converter and the second photoelectric converter; and
a third signal detection circuit connected to the third photoelectric converter.

10. The imaging device according to claim 1 or 2, wherein
a first one of the first photoelectric converter and the second photoelectric converter has sensitivity to a near-infrared wavelength region, and
a second one of the first photoelectric converter and the second photoelectric converter has sensitivity to a visible light wavelength region.

11. The imaging device according to claim 10, wherein an exposure period of the first one of the first photoelectric converter and the second photoelectric converter is shorter than an exposure period of the second one of the first photoelectric converter and the second photoelectric converter.

12. The imaging device according to claim 1 or 2, wherein the second photoelectric converter includes a silicon photodiode.

13. A camera system comprising:
the imaging device according to claim 1 or 2; and
a lighting device that emits light including a luminescence peak in a wavelength range to which at least one of the first photoelectric converter and the second photoelectric converter has sensitivity,
wherein the lighting device emits the light in a period overlapping an exposure period of the at least one of the first photoelectric converter and the second photoelectric converter.
